# EUROPÄISCHE PATENTSCHRIFT

(11) **EP 2 401 316 B1**
(45) Veröffentlichungstag und Bekanntmachung des Hinweises auf die Patenterteilung: **24.05.2017**
(21) Anmeldenummer: 10703414.2
(22) Anmeldetag: 01.02.2010
(51) Int. Cl.: C08G 61/12, C09D 165/00

(54) **POLYMER MIT ALDEHYDGRUPPEN, UMSETZUNG SOWIE VERNETZUNG DIESES POLYMERS, VERNETZTES POLYMER SOWIE ELEKTROLUMINESZENZVORRICHTUNG ENTHALTEND DIESES POLYMER**
POLYMER HAVING ALDEHYDE GROUPS, CONVERTING AND CROSS-LINKING OF SAID POLYMER, CROSS-LINKED POLYMER, AND ELECTROLUMINESCENT DEVICE COMPRISING SAID POLYMER
POLYMÈRE COMPORTANT DES GROUPES ALDÉHYDE, TRANSFORMATION AINSI QUE RÉTICULATION DE CE POLYMÈRE, POLYMÈRE RÉTICULÉ AINSI QUE DISPOSITIF ÉLECTROLUMINESCENT CONTENANT CE POLYMÈRE

(30) Priorität: 27.02.2009 DE 102009010713; 22.12.2009 DE 102009059985
(43) Veröffentlichungstag der Anmeldung: 04.01.2012
(73) Patentinhaber: Merck Patent GmbH, 64293 Darmstadt (DE)
(72) Erfinder: LUDEMANN, Aurélie, 60322 Frankfurt (DE); ANEMIAN, Rémi, Manouk, Seoul 657-169 (KR); JULLIART, Alice, 60311 Frankfurt (DE)
(86) Internationale Anmeldenummer: PCT/EP2010/000590
(87) Internationale Veröffentlichungsnummer: WO 2010/097155

(56) Entgegenhaltungen:
- WO-A1-2006/043087
- WO-A1-2010/065178
- XIA H ET AL: "A facile convergent procedure for the preparation of triphenylamine-based dendrimers with truxene cores" TETRAHEDRON, ELSEVIER SCIENCE PUBLISHERS, AMSTERDAM, NL, Bd. 64, Nr. 24, 9. Juni 2008 (2008-06-09), Seiten 5736-5742, XP022658984 ISSN: 0040-4020 [gefunden am 2008-04-09]
- DATABASE CA [Online] CHEMICAL ABSTRACTS SERVICE, COLUMBUS, OHIO, US; 18. Juli 2003 (2003-07-18), NOGUCHI, TAKANOBU ET AL: "Process for production of high-molecular compounds useful for polymer LED or the like" XP002574884 gefunden im STN Database accession no. 2003:551570 -& WO 03/057762 A1 (SUMITOMO CHEMICAL COMPANY, LIMITED, JAPAN) 17. Juli 2003 (2003-07-17)
- QIANG FANG; TAKAKAZU YAMAMOTO: "New Alternative Copolymer Constituted of Fluorene and Triphenylamine Units with a Tunable -CHO Group in the Side Chain. Quantitative Transformation of the -CHO Group to -CH=CHAr Groups and Optical and Electrochemical Properties of the Polymers" MACROMOLECULES, Bd. 37, 3. Juli 2004 (2004-07-03), Seiten 5894-5899, XP002574885

## Beschreibung

Die vorliegende Erfindung betrifft ein Polymer, das mindestens eine Struktureinheit umfasst, die mindestens eine Aldehydgruppe aufweist, und ein Verfahren zur Herstellung eines vernetzbaren und/oder vernetzten Polymers unter Einbeziehung eines Polymers das Aldehydgruppen aufweist. Das erfindungsgemäße Verfahren zur Herstellung eines vernetzten Polymers unter Einbeziehung eines aldehydgruppenhaltigen Polymers führt zu Polymeren mit einem hervorragenden Vernetzungsgrad. Somit betrifft die vorliegende Erfindung auch ein vernetztes Polymer, das durch das erfindungsgemäße Verfahren hergestellt wird, die Verwendung dieses vernetzten Polymers in elektronischen Vorrichtungen, insbesondere in organischen Elektrolumineszenzvorrichtungen, sogenannten OLEDs (OLED = Organic Light Emitting Diodes), sowie organische Elektrolumineszenzvorrichtungen enthaltend dieses vernetzte Polymer. Die vorliegende Erfindung betrifft auch die Verwendung des erfindungsgemäßen aldehydgruppenhaltigen Polymers zur Herstellung eines vinyl-oder alkenylgruppenhaltigen Polymers oder eines vernetzten Polymers.

In optoelektronischen Vorrichtungen, wie OLEDs, insbesondere PLEDs (Polymeric Light Emitting Diodes), werden Komponenten verschiedener Funktionalität benötigt. In PLEDs liegen die verschiedenen Funktionalitäten normalerweise in verschiedenen Polymer-Schichten vor. In diesem Fall spricht man von mehrschichtigen OLED-Systemen. Diese mehrschichtigen OLED-Systeme weisen - unter anderem - ladungstransportierende Schichten, wie Elektronen- und Lochleiterschichten, sowie Schichten auf, die lichtemittierende Komponenten beinhalten. Diese mehrschichtigen OLED-Systeme werden in der Regel durch das aufeinanderfolgende schichtweise Aufbringen von Polymerlösungen, die Polymere mit den verschiedenen Funktionalitäten aufweisen, und das Vernetzen der jeweils aufgebrachten Polymerschicht, um sie unlöslich zu machen bevor die nächste Schicht aufgebracht wird, hergestellt. Solche Verfahren werden z.B. in der EP 0 637 899 und der WO 96/20253 beschrieben.

In der Mehrzahl der Fälle wird die vernetzende Gruppe direkt an ein Monomer gebunden, das dann durch Polymerisation Bestandteil eines vernetzbaren Polymers wird. Diese Herstellungsroute für vernetzte Polymere wird z.B. in der WO 2006/043087, der WO 2005/049689, der WO 2005/052027 und der US 2007/0228364 beschrieben. Das Problem, das mit der Polymerisation von Monomeren, die bereits während der Polymerisation eine vernetzbare Gruppe tragen, einhergeht, ist die unerwünschte Vernetzung schon bei der Herstellung des Polymers. Um diese Nachteile zu vermeiden, ist es demnach notwendig, dass die vernetzbare Gruppe unter den Polymerisationsbedingungen stabil bleibt und keine Reaktionen eingeht, um erst anschließend gezielt zur Vernetzung beitragen zu können. Gewöhnliche Polymerisationsbedingungen, wie z.B. bei der Stille-, Suzuki- oder Yamamoto-Kupplung, erfordern höhere Temperaturen als Raumtemperatur. Bei diesen Temperaturen können vernetzbare Gruppen schon während der Polymerisation unerwünschte Nebenreaktionen mit weiteren Vernetzungsmonomeren und/oder eventuell vorhandenen weiteren Comonomeren eingehen. Dies kann die Verarbeitbarkeit des Polymeren einschränken, zu Materialdefekten führen sowie die Leistungsfähigkeit und/oder Kapazität der resultierenden Vorrichtungen erniedrigen. Diese Probleme werden von den im Stand der Technik verwendeten Verfahren nicht zufriedenstellend gelöst.

Es war demnach eine Aufgabe der vorliegenden Erfindung, eine Möglichkeit zu finden, wie Nebenreaktionen der vernetzbaren Gruppe bei der Polymerisation von Monomeren vermieden werden können, so dass die Polymerisation ungestört abläuft, und das erhaltene Polymer die gewünschte Anzahl von vernetzbaren Gruppen aufweist.

Die erfindungsgemäße Aufgabe wird zum einen durch das Bereitstellen eines Polymers gelöst, das selbst noch keine vernetzbaren Gruppen trägt, aber Gruppen aufweist, die leicht und quantitativ in vernetzbare Gruppen überführt werden können.

Gegenstand der vorliegenden Erfindung ist somit ein Polymer, das mindestens eine Struktureinheit der folgenden Formel (I) umfasst: 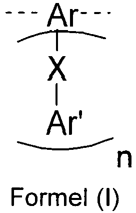 die dadurch gekennzeichnet ist, dass zumindest ein Vertreter aus Ar und Ar', vorzugsweise Ar', eine Aldehydgruppe aufweist,
wobei die verwendeten Symbole und Indices die folgenden Bedeutungen haben:
- Ar und Ar': stellen unabhängig voneinander ein substituiertes oder unsubstituiertes, mono- oder polycyclisches, aromatisches oder heteroaromatisches Ringsystem dar;
- X: stellt eine kovalente Einfachbindung oder eine geradkettige, verzweigte oder cyclische C₁₋₁₀-Alkylen-, C₁₋₁₀-Alkenylen- oder C₁₋₁₀-Alkinylengruppe dar, in der ein oder mehrere H-Atome durch F ersetzt sein können und in der eine oder mehrere CH₂-Gruppen durch O, NH oder S ersetzt sein können; und
- n: ist 1, 2, 3 oder 4, vorzugsweise 1 oder 2 und besonders bevorzugt 1; und
die gestrichelten Linien stellen Bindungen zur nächsten Struktureinheit des Polymers dar wie weiter spezifiziert in Anspruch 1. Unter dem Begriff "Struktureinheit" versteht man in der vorliegenden Erfindung eine Monomereinheit, die durch Reaktion an zwei Enden durch Verbindungsknüpfung als ein Teil des Polymergrundgerüstes in dieses eingebaut wurde, und damit im hergestellten Polymer als Wiederholungseinheit im Polymer verknüpft vorliegt.

In der vorliegenden Anmeldung sind unter dem Begriff Polymer sowohl polymere Verbindungen, oligomere Verbindungen, sowie Dendrimere zu verstehen. Die erfindungsgemäßen polymeren Verbindungen weisen vorzugsweise 10 bis 10000, besonders bevorzugt 20 bis 5000 und insbesondere 50 bis 2000 Struktureinheiten auf. Die erfindungsgemäßen oligomeren Verbindungen weisen vorzugsweise 3 bis 9 Struktureinheiten auf. Der Verzweigungs-Faktor der Polymere liegt dabei zwischen 0 (lineares Polymer, ohne Verzweigungsstellen) und 1 (vollständig verzweigtes Dendrimer).

Unter dem Begriff "Dendrimer" soll in der vorliegenden Anmeldung eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum als auch die Monomere beliebige verzweigte Strukturen annehmen, die sowohl aus rein organischen Einheiten als auch Organometallverbindungen oder Koordinationsverbindungen bestehen. "Dendrimer" soll hier allgemein so verstanden werden, wie dies z.B. von M. Fischer und F. Vögtle (Angew. Chem., Int. Ed. 1999, 38, 885) beschrieben ist.

Unter "substituiertes oder unsubstituiertes, mono- oder polycyclisches, aromatisches Ringsystem" wird in der vorliegenden Offenbarung ein aromatisches Ringsystem mit vorzugsweise 6 bis 60, besonders bevorzugt 6 bis 30, ganz besonders bevorzugt 6 bis 14 und insbesonders bevorzugt 6 bis 10 aromatischen Ringatomen verstanden, das nicht notwendigerweise nur aromatische Gruppen enthält, sondern in dem auch mehrere aromatische Einheiten durch eine kurze nicht-aromatische Einheit (< 10 % der von H verschiedenen Atome, vorzugsweise < 5 % der von H verschiedenen Atome), wie beispielsweise sp³-hybridisiertes C-Atom bzw. O- oder N-Atom, CO-Gruppe etc., unterbrochen sein können. So sollen beispielsweise auch Systeme wie 9,9'-Spirobifluoren, 9,9-Diarylfluoren, etc. als aromatische Ringsysteme verstanden werden.

Die aromatische Ringsysteme können monocyclisch oder polycyclisch sein, d.h. sie können einen Ring (z.B. Phenyl) oder mehrere Ringe aufweisen, welche auch kondensiert (z.B. Naphthyl) oder kovalent verknüpft sein können (z.B. Biphenyl), oder eine Kombination von kondensierten und verknüpften Ringen beinhalten. Besonders bevorzugt sind jedoch vollständig kondensierte Systeme.

Bevorzugte aromatische Ringsysteme sind z.B. Phenyl, Biphenyl, Triphenyl, [1,1':3',1"]Terphenyl-2'-yl, Naphthyl, Anthracen, Binaphthyl, Phenanthren, Dihydrophenanthren, Pyren, Dihydropyren, Chrysen, Perylen, Tetracen, Pentacen, Benzpyren, Fluoren, Inden, Indenofluoren und Spirobifluoren.

Unter dem Begriff "substituiertes oder unsubstituiertes, mono- oder polycyclisches, heteroaromatisches Ringsystem" wird in der vorliegenden Erfindung ein aromatisches Ringsystem mit vorzugsweise 5 bis 60, besonders bevorzugt 5 bis 30, ganz besonders bevorzugt 5 bis 20 und insbesonders bevorzugt 5 bis 9 aromatischen Ringatomen verstanden, wobei ein oder mehrere dieser Atome ein Heteroatom ist/sind.

Das "substituierte oder unsubstituierte, mono- oder polycyclische, heteroaromatische Ringsystem" enthält nicht notwendigerweise nur aromatische Gruppen, sondern kann auch durch eine kurze nicht-aromatische Einheit (< 10 % der von H verschiedenen Atome, vorzugsweise < 5 % der von H verschiedenen Atome), wie beispielsweise sp³-hybridisiertes C-Atom bzw. O- oder N-Atom, CO-Gruppe etc., unterbrochen sein.

Die heteroaromatischen Ringsysteme können monocyclisch oder polycyclisch sein, d.h. sie können einen Ring oder mehrere Ringe aufweisen, welche auch kondensiert oder kovalent verknüpft sein können (z.B. Pyridylphenyl), oder eine Kombination von kondensierten und verknüpften Ringen beinhalten. Bevorzugt sind vollständig konjugierte Heteroarylgruppen. Besonders bevorzugt sind jedoch vollständig kondensierte Systeme.

Bevorzugte heteroaromatische Ringsysteme sind z.B. 5-gliedrige Ringe wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder kondensierte Gruppen wie Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen oder Kombinationen dieser Gruppen. Die Heteroarylgruppen können auch mit Alkyl, Alkoxy, Thioalkyl, Fluor, Fluoralkyl oder weiteren Aryl- oder Heteroarylgruppen substituiert sein.

Das substituierte oder unsubstituierte mono- oder polycyclische aromatische oder heteroaromatische Ringsystem weist gegebenenfalls einen oder mehrere Substituenten auf, welche vorzugsweise ausgewählt sind aus der Gruppe bestehend aus Silyl, Sulfo, Sulfonyl, Formyl, Amin, Imin, Nitril, Mercapto, Nitro, Halogen, C₁₋₁₂-Alkyl, C₆₋₁₂-Aryl, C₁₋₁₂-Alkoxy, Hydroxy oder Kombinationen dieser Gruppen.

Bevorzugte Substituenten sind beispielsweise löslichkeitsfördernde Gruppen wie Alkyl oder Alkoxy, elektronenziehende Gruppen wie Fluor, Nitro oder Nitril, oder Substituenten zur Erhöhung der Glastemperatur (Tg) im Polymer, insbesondere voluminöse Gruppen, wie z.B. t-Butyl oder gegebenenfalls substituierte Arylgruppen.

Besonders bevorzugte Substituenten sind z.B. F, Cl, Br, I, -CN, -NO_{2,} -NCO, -NCS, -OCN, -SCN, -C(=O)N(R)₂, -C(=O)Y¹, -C(=O)R und -N(R)₂, worin R unabhängig voneinander H, ein aliphatischer oder aromatischer Kohlenwasserstoffrest mit 1 bis 20 C-Atomen ist und Y¹ Halogen bedeutet, optional substituiertes Silyl, Aryl mit 4 bis 40, vorzugsweise 6 bis 20 C-Atomen, und geradkettiges oder verzweigtes Alkyl, Alkoxy, Alkylcarbonyl, Alkoxycarbonyl, Alkylcarbonyloxy oder Alkoxycarbonyloxy mit 1 bis 22 C-Atomen, worin ein oder mehrere H-Atome gegebenenfalls durch F oder Cl ersetzt sein können.

Unter dem Begriff "aromatische Einheit" versteht man im Sinne der vorliegenden Erfindung eine Verbindungseinheit, die als solches ein aromatisches System bildet, das gemäß der Definition nach HÜCKEL ein cyclisch konjugiertes System mit (4n+2)-π-Etektronen ist, wobei n eine ganze Zahl darstellt.

Unter einer "geradkettigen, verzweigten oder cyclischen C₁₋₁₀-Alkylen-, C₁₋₁₀-Alkenylen- oder C₁₋₁₀-Alkinylengruppe" versteht man gesättigte oder ungesättigte aliphatische Kohlenwasserstoffe, die vorzugsweise 1 bis 10 Kohlenstoffatome, besonders bevorzugt 1 bis 6 Kohlenstoffatome enthalten, wobei auch eine oder mehrere CH₂-Gruppen durch NH, O oder S ersetzt sein können, und auch ein oder mehrere H-Atome durch F ersetzt sein können. Insbesonders bevorzugt sind hierbei lineare gesättigte Kohlenwasserstoffe mit 1 bis 6 Kohlenstoffatomen. Beispiele der aliphatischen Kohlenwasserstoffe mit 1 bis 10 Kohlenstoffatomen schließen die folgenden ein: Methylen, Ethylen, n-Propylen, iso-Propylen, n-Butylen, iso-Butylen, sec-Butylen (1-Methylpropylen), tert-Butylen, iso-Pentylen, n-Pentylen, tert-Pentylen (1,1- Dimethylpropyl), 1,2-Dimethylpropylen, 2,2-Dimethylpropylen (Neopentyl), 1-Ethylpropylen, 2-Methylbutylen, n-Hexylen, iso-Hexylen, 1,2-Dimethylbutylen, 1-Ethyl-1-methylpropylen, 1-Ethyl-2-methylpropylen, 1,1,2-Trimethylpropylen, 1,2,2-Trimethylpropylen, 1-Ethylbutylen, 1-Methylbutylen, 1,1-Dimethylbutylen, 2,2-Dimethylbutylen, 1,3-Dimethylbutylen, 2,3-Dimethylbutylen, 3,3-Dimethylbutylen, 2-Ethylbutylen, 1-Methylpentylen, 2-Methylpentylen, 3-Methylpentylen, Cyclopentylen, Cyclohexylen, Cycloheptylen, Cyclooctylen, 2-Ethylhexylen, Trifluormethylen, Pentafluorethylen, 2,2,2-Trifluorethylen, Ethenylen, Propenylen, Butenylen, Pentenylen, Cyclopentenylen, Hexenylen, Cyclohexenylen, Heptenylen, Cycloheptenylen, Octenylen, Cyclooctenylen, Ethinylen, Propinylen, Butinylen, Pentinylen, Hexinylen und Octinylen.

Der Anteil vernetzbarer Struktureinheiten gemäß Formel (I) liegt im Polymer im Bereich von 1 bis 30 mol%, bezogen auf 100 mol% aller copolymerisierten Monomere, die im Polymer als Struktureinheiten enthalten sind.

In einer weiteren bevorzugten Ausführungsform der vorliegenden Offenbarung enthält das erfindungsgemäße Polymer neben einer oder mehrerer Struktureinheiten der Formel (I) noch mindestens eine weitere Struktureinheit, die von der Struktureinheit der Formel (I) verschieden ist. Dies sind unter anderem solche, wie sie in der WO 02/077060 A1 und in der WO 2005/014689 A2 offenbart und umfangreich aufgelistet sind. Diese werden via Zitat als Bestandteil der vorliegenden Erfindung betrachtet. Die weiteren Struktureinheiten können beispielsweise aus den folgenden Klassen stammen:
- Gruppe 1:: Einheiten, welche die Lochinjektions- und/oder Lochtransporteigenschaften der Polymere erhöhen;
- Gruppe 2:: Einheiten, welche die Elektroneninjektions- und/oder Elektronentransporteigenschaften der Polymere erhöhen;
- Gruppe 3:: Einheiten, die Kombinationen von Einzeleinheiten der Gruppe 1 und Gruppe 2 aufweisen;
- Gruppe 4:: Einheiten, welche die Emissionscharakteristik insoweit verändern, dass Elektrophosphoreszenz statt Elektrofluoreszenz erhalten werden kann;
- Gruppe 5:: Einheiten, welche den Übergang vom so genannten Singulettzum Triplettzustand verbessern;
- Gruppe 6:: Einheiten, welche die Emissionsfarbe der resultierenden Polymere beeinflussen;
- Gruppe 7:: Einheiten, welche typischerweise als Backbone verwendet werden;
- Gruppe 8:: Einheiten, welche die Filmmorphologie und/oder die rheologischen Eigenschaften der resultierenden Polymere beeinflussen.

Bevorzugte erfindungsgemäße Polymere sind solche, bei denen mindestens eine Struktureinheit Ladungstransporteigenschaften aufweist, d. h. die Einheiten aus der Gruppe 1 und/oder 2 enthalten.

Struktureinheiten aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen mit hoch liegendem HOMO (HOMO = höchstes besetztes Molekülorbital). Vorzugsweise führen diese Arylamine und Heterocyclen zu einem HOMO im Polymer von mehr als -5,8 eV (gegen Vakuumlevel), besonders bevorzugt von mehr als -5,5 eV.

Struktureinheiten aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital). Vorzugsweise führen diese Einheiten im Polymer zu einem LUMO von weniger als -2,5 eV (gegen Vakuumlevel), besonders bevorzugt von weniger als -2,7 eV.

Es kann bevorzugt sein, wenn in den erfindungsgemäßen Polymeren Einheiten aus der Gruppe 3 enthalten sind, in denen Strukturen, welche die Lochmobilität und welche die Elektronenmobilität erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Struktureinheiten der Gruppe 4 sind solche, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o. g. Bedingung erfüllen. Besonders bevorzugt sind hier entsprechende Struktureinheiten, welche Elemente der Gruppe 8 bis 10 (Ru, Os, Rh, Ir, Pd, Pt) enthalten. Als Struktureinheiten für die erfindungsgemäßen Polymere kommen hier z.B. verschiedene Komplexe in Frage, wie sie z.B. in der WO 02/068435 A1, der WO 02/081488 A1, der EP 1239526 A2 und der WO 2004/026886 A2 beschrieben werden. Entsprechende Monomere werden in der WO 02/068435 A1 und in der WO 2005/042548 A1 beschrieben.

Struktureinheiten der Gruppe 5 sind solche, welche den Übergang vom Singulett- zum Triplettzustand verbessern und welche, unterstützend zu den Strukturelementen der Gruppe 4 eingesetzt, die Phosphoreszenzeigenschaften dieser Strukturelemente verbessern. Hierfür kommen insbesondere Carbazol- und überbrückte Carbazoldimereinheiten in Frage, wie sie z.B. in der WO 2004/070772 A2 und der WO 2004/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 beschrieben werden.

Struktureinheiten der Gruppe 6 sind neben den oben genannten solche, die mindestens noch eine weitere aromatische oder eine andere konjugierte Struktur aufweisen, welche nicht unter die o. g. Gruppen fallen, d. h. die die Ladungsträgermobilitäten nur wenig beeinflussen, die keine metallorganischen Komplexe sind oder die keinen Einfluss auf den Singulett-Triplett-Übergang haben. Derartige Strukturelemente können die Emissionsfarbe der resultierenden Polymere beeinflussen. Je nach Einheit können sie daher auch als Emitter eingesetzt werden. Bevorzugt sind dabei aromatische Strukturen mit 6 bis 40 C-Atomen oder auch Tolan-, Stilben-oder Bisstyrylarylenderivate, die jeweils mit einem oder mehreren Resten R substituiert sein können. Besonders bevorzugt ist dabei der Einbau von 1,4-Phenylen-, 1,4-Naphthylen-, 1,4- oder 9,10-Anthrylen-, 1,6-, 2,7- oder 4,9-Pyrenylen-, 3,9- oder 3,10-Perylenylen-, 4,4'-Biphenylylen-, 4,4"-Terphenylylen, 4,4'-Bi-1,1'-naphthylylen-, 4,4'-Tolanylen-, 4,4'-Stilbenylen-, 4,4"-Bisstyrylarylen-, Benzothiadiazol- und entsprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- oder Perylenderivaten, die vorzugsweise substituiert sind, oder vorzugsweise konjugierte Push-Pull-Systeme (Systeme, die mit Donor- und Akzeptorsubstituenten substituiert sind) oder Systeme wie Squarine oder Chinacridone, die vorzugsweise substituiert sind.

Struktureinheiten der Gruppe 7 sind Einheiten, die aromatische Strukturen mit 6 bis 40 C-Atomen beinhalten, welche typischerweise als Polymergrundgerüst (Backbone) verwendet werden. Dies sind beispielsweise 4,5-Dihydropyrenderivate, 4,5,9,10-Tetrahydropyrenderivate, Fluorenderivate, 9,9'-Spirobifluorenderivate, Phenanthrenderivate, 9,10-Dihydrophenanthrenderivate, 5,7-Dihydrodibenzooxepinderivate und cis-und trans-Indenofluorenderivate.

Struktureinheiten der Gruppe 8 sind solche, die die Filmmorphologie und/oder die rheologischen Eigenschaften der Polymere beeinflussen, wie z.B. Siloxane, lange Alkylketten oder fluorierte Gruppen, aber auch besonders steife oder flexible Einheiten, wie z.B. flüssigkristallbildende Einheiten oder vernetzbare Gruppen.

Bevorzugt sind erfindungsgemäße Polymere, die gleichzeitig neben Struktureinheiten der Formel (I) zusätzlich noch ein oder mehrere Einheiten ausgewählt aus den Gruppen 1 bis 8 enthalten. Es kann ebenfalls bevorzugt sein, wenn gleichzeitig mehr als eine weitere Struktureinheit aus einer Gruppe vorliegt.

Bevorzugt sind dabei erfindungsgemäße Polymere, die neben mindestens einer Struktureinheit der Formel (I) noch Einheiten aus der Gruppe 7 enthalten, besonders bevorzugt mindestens 50 mol% dieser Einheiten, bezogen auf die Gesamtzahl der Struktureinheiten im Polymer.

Ebenfalls bevorzugt ist es, wenn die erfindungsgemäßen Polymere Einheiten enthalten, die den Ladungstransport oder die Ladungsinjektion verbessern, also Einheiten aus der Gruppe 1 und/oder 2; besonders bevorzugt ist ein Anteil von 0,5 bis 30 mol% dieser Einheiten; ganz besonders bevorzugt ist ein Anteil von 1 bis 10 mol% dieser Einheiten. Die erfindungsgemäßen Polymere enthalten Struktureinheiten aus der Gruppe 7 und Einheiten aus der Gruppe 1 und/oder 2, insbesondere mindestens 50 mol% Einheiten aus der Gruppe 7 und 0,5 bis 30 mol% Einheiten aus der Gruppe 1 und/oder 2.

Die erfindungsgemäßen Polymere sind entweder Homopolymere aus Struktureinheiten der Formel (I) oder Copolymere. Die erfindungsgemäßen Polymere können linear oder verzweigt sein, vorzugsweise linear. Erfindungsgemäße Copolymere können dabei neben einer oder mehreren Struktureinheiten der Formel (I) potentiell eine oder mehrere weitere Strukturen aus den oben aufgeführten Gruppen 1 bis 8 besitzen.

Die erfindungsgemäßen Copolymere können statistische, alternierende oder blockartige Strukturen aufweisen oder auch mehrere dieser Strukturen abwechselnd besitzen. Besonders bevorzugt weisen die erfindungsgemäßen Copolymere statistische oder alternierende Strukturen auf. Besonders bevorzugt sind die Copolymere statistische oder alternierende Copolymere. Wie Copolymere mit blockartigen Strukturen erhalten werden können und welche weiteren Strukturelemente dafür besonders bevorzugt sind, ist beispielsweise ausführlich in der WO 2005/014688 A2 beschrieben. Ebenso sei an dieser Stelle nochmals hervorgehoben, dass das Polymer auch dendritische Strukturen haben kann.

In einer weiteren Ausführungsform ist Ar' der Formel (I) vorzugsweise eine substituierte oder unsubstituierte Einheit, die aus der Gruppe ausgewählt ist, die aus folgendem besteht:
Phenylen, Biphenylen, Triphenylen, [1,1':3',1"]Terphenyl-2'-ylen, Naphthylen, Anthracen, Binaphthylen, Phenanthren, Dihydrophenanthren, Pyren, Dihydropyren, Chrysen, Perylen, Tetracen, Pentacen, Benzo[a]pyren, Fluoren, Inden, Indenofluoren, Spirobifluoren, Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen und Benzothiadiazothiophen, wobei die optionalen Substituenten die sind, die oben für die aromatischen und heteroaromatischen Ringsysteme beschrieben sind. Besonders bevorzugt sind Naphtylen und Phenylen, wobei Phenylen insbesonders bevorzugt ist.

In einer noch weiteren Ausführungsform ist es bevorzugt, dass X in der Struktureinheit der Formel (I) eine kovalente Einfachbindung ist.

Eine weitere Ausführungsform der vorliegenden Erfindung ist auch ein Polymer, das mindestens eine Struktureinheit der folgenden Formel (II) umfasst: 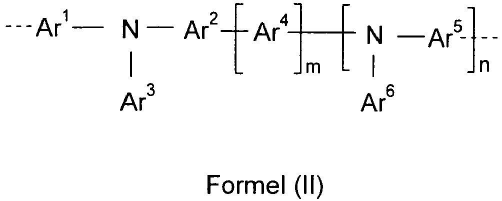 die dadurch gekennzeichnet ist, dass zumindest ein Ar der Einheiten Ar¹ bis Ar⁶ eine Aldehydgruppe aufweist,
wobei die verwendeten Symbole und Indices die folgenden Bedeutungen haben:
- Ar¹ bis Ar⁶: sind gleich oder verschieden und stellen unabhängig voneinander ein substituiertes oder unsubstituiertes, mono- oder polycyclisches, aromatisches oder heteroaromatisches Ringsystem mit 5 bis 25 Ringatomen dar;
- m: ist 0 oder 1;
- n: ist 0, 1 oder 2;
die gestrichelten Linien stellen Bindungen zur nächsten Struktureinheit des Polymers dar;
mit der Maßgabe, dass, wenn n = 1 ist, die beiden N-Atome an verschiedene C-Atome des gleichen aromatischen Ringsystems binden.

Im Fall von n = 2, können die beiden in der entsprechenden eckigen Klammer enthaltenen Strukturelemente entweder in Reihe angeordnet sein, was zu einer linearen Struktureinheit der Formel (II) führt, oder parallel (d.h. beide an Ar² bzw Ar⁴) angeordnet sein, was zu einer verzweigten Strukureinheit der Formel (II) führt.

In einer weiteren Ausführungsform der vorliegenden Erfindung ist es bevorzugt, dass Ar¹ bis Ar⁶, unabhängig voneinander, gleich oder verschieden ausgewählt sind aus der Gruppe bestehend aus: Phenylen, Biphenylen, Triphenylen, [1,1':3',1"]Terphenyl-2'-ylen, Naphthylen, Anthracen, Binaphthylen, Phenanthren, Dihydrophenanthren, Pyren, Dihydropyren, Chrysen, Perylen, Tetracen, Pentacen, Benzo[a]pyren, Fluoren, Inden, Indenofluoren, Spirobifluoren, Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen und Benzothiadiazothiophen, wobei die optionalen Substituenten die sind, die oben für die aromatischen und heteroaromatischen Ringsysteme beschrieben sind. Besonders bevorzugt sind Naphtylen und Phenylen, wobei Phenylen insbesonders bevorzugt ist.

In einer weiteren Ausführungsform der vorliegenden Erfindung ist es besonders bevorzugt, dass Ar der Formel (I) bzw. Ar¹, Ar², Ar⁴ und Ar⁵ der Formel (II) eine substituierte oder unsubstituierte Einheit ist, die aus der Gruppe ausgewählt ist, die aus folgendem besteht:
4,5-Dihydropyren, 4,5,9,10-Tetrahydrofluoren, 9,9'-Spirobifluoren, Fluoren, Phenanthren, 9,10-Dihydrophenanthren, 5,7-Dihydrodibenzooxepin, cis-Indenofluoren, trans-Indenofluoren, Phenylen, Thiophen, Benzanthracen, Carbazol, Benzimidazol, Oxepin und Triazin.

Zudem ist es bevorzugt, dass das Polymer der vorliegenden Erfindung als weitere Struktureinheit eine Struktureinheit der Formel (I) und/oder (II) umfasst, die jedoch keine Aldehydgruppe aufweist.

Des Weiteren weist die Struktureinheit der Formel (II) des erfindungsgemäßen Polymers vorzugsweise eine Aldehydgruppe an dem Rest Ar³ und/oder Ar⁶ und die Struktureinheit Ar' der Formel (I) des erfindungsgemäßen Polymers eine Aldehydgruppe auf. Die Gruppen Ar³, Ar⁶ und Ar' stellen vorzugsweise eine Phenylgruppe dar, die eine Aldehydgruppe aufweisen können. Die Aldehydgruppe kann sich in ortho-, meta- oder para-Stellung an der Phenylgruppe befinden. Bevorzugt befindet sich die Aldehydgruppe in para-Stellung.

In einer weiteren Ausführungsform der vorliegenden Erfindung ist es bevorzugt, dass, wenn m und n in Formel (II) gleich null sind, einer der Reste Ar¹, Ar² und Ar³ verschieden von Phenyl ist. In diesem Fall ist es bevorzugt, dass Ar¹ und/oder Ar² verschieden von Phenyl ist.

In einer besonders bevorzugten Ausführungsform umfasst das erfindungsgemäße Polymer mindestens eine der folgenden Struktureinheiten: 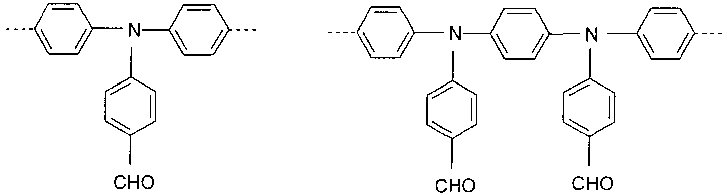 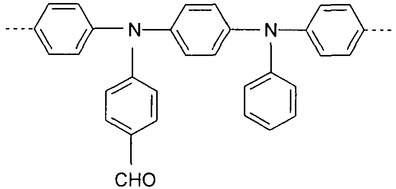 In einer weiteren Ausführungsform der vorliegenden Offenbarung umfasst das Polymer vorzugsweise eine oder mehrere der folgenden Struktureinheiten:

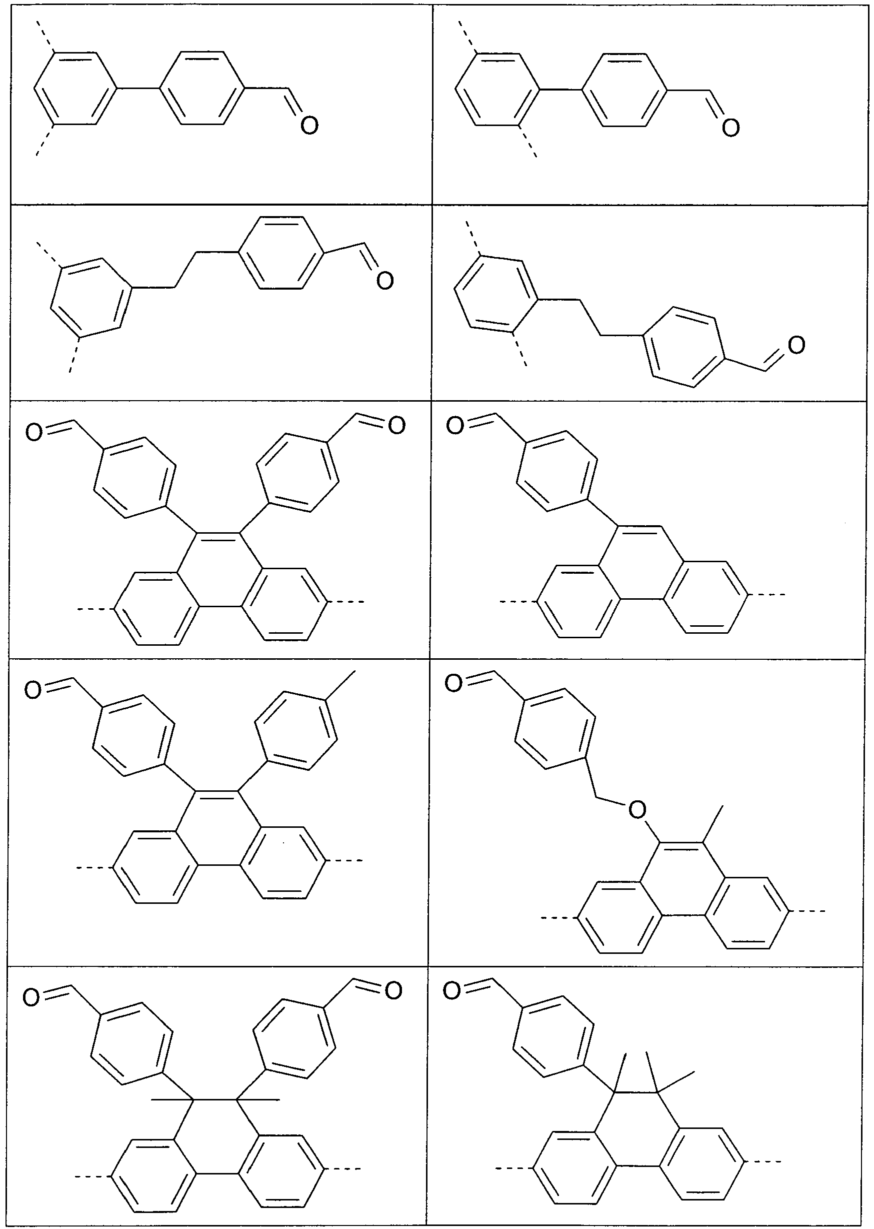

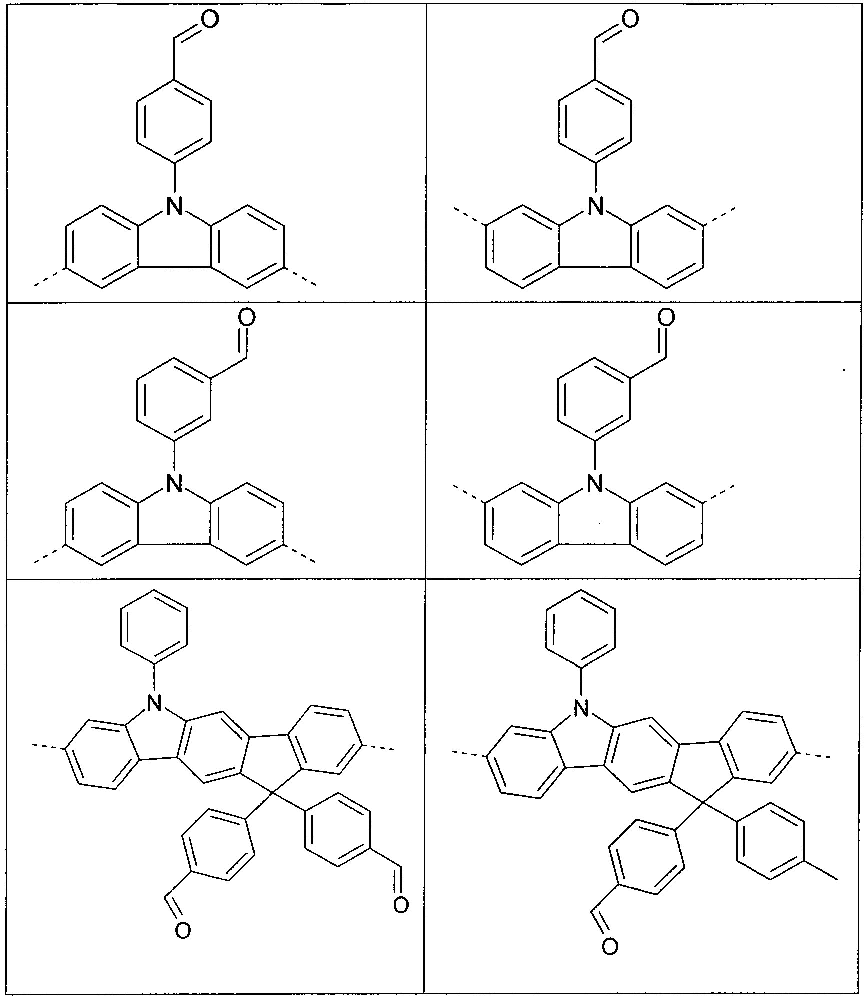

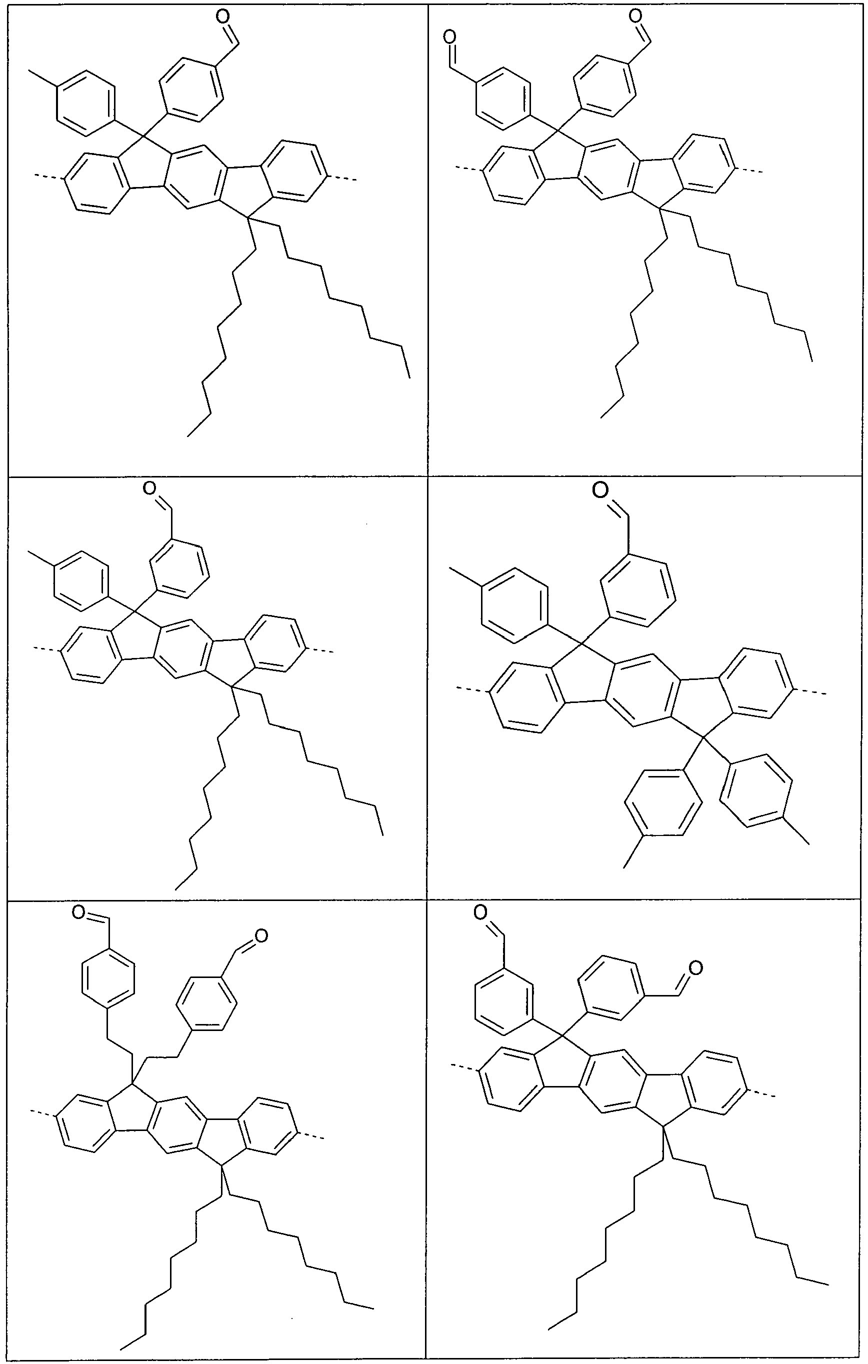

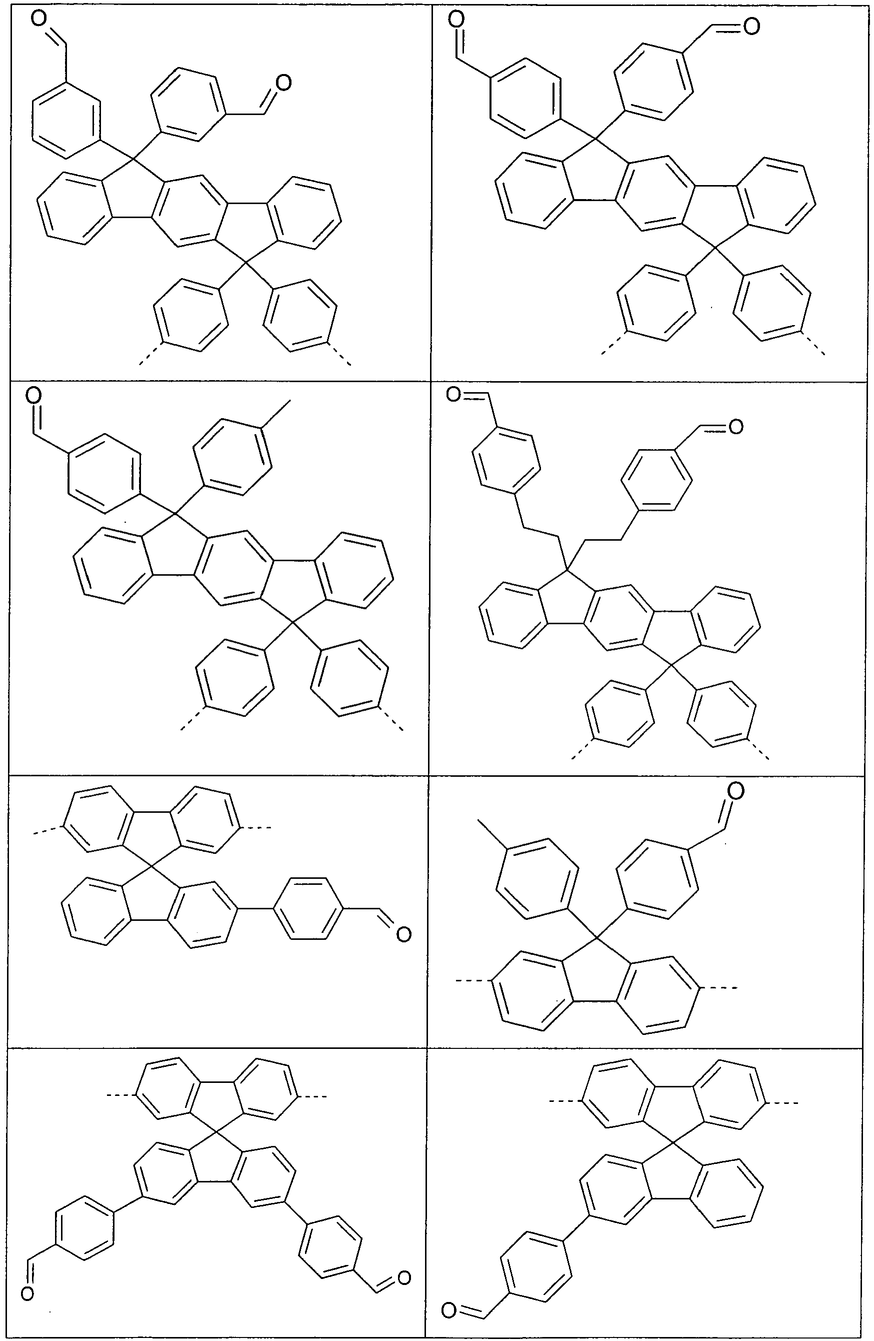

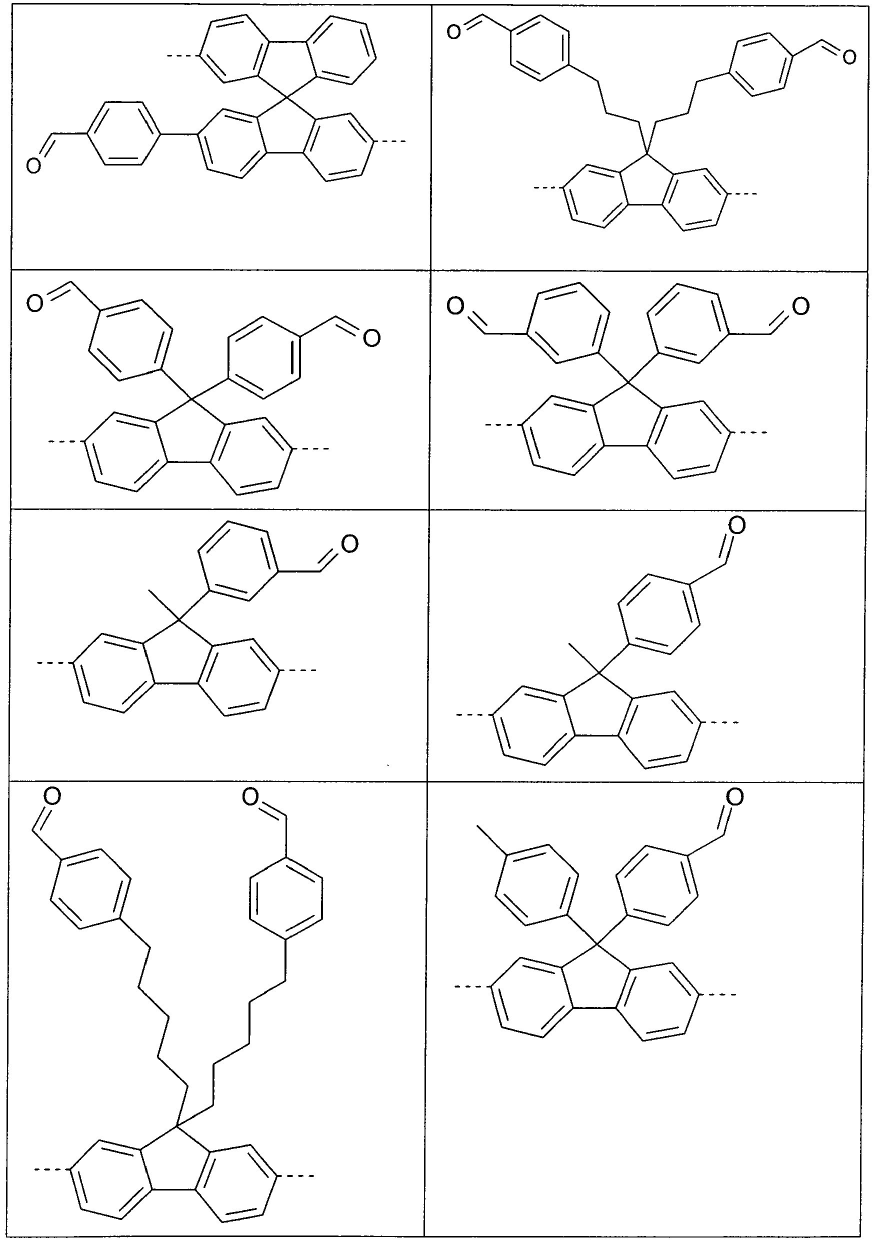

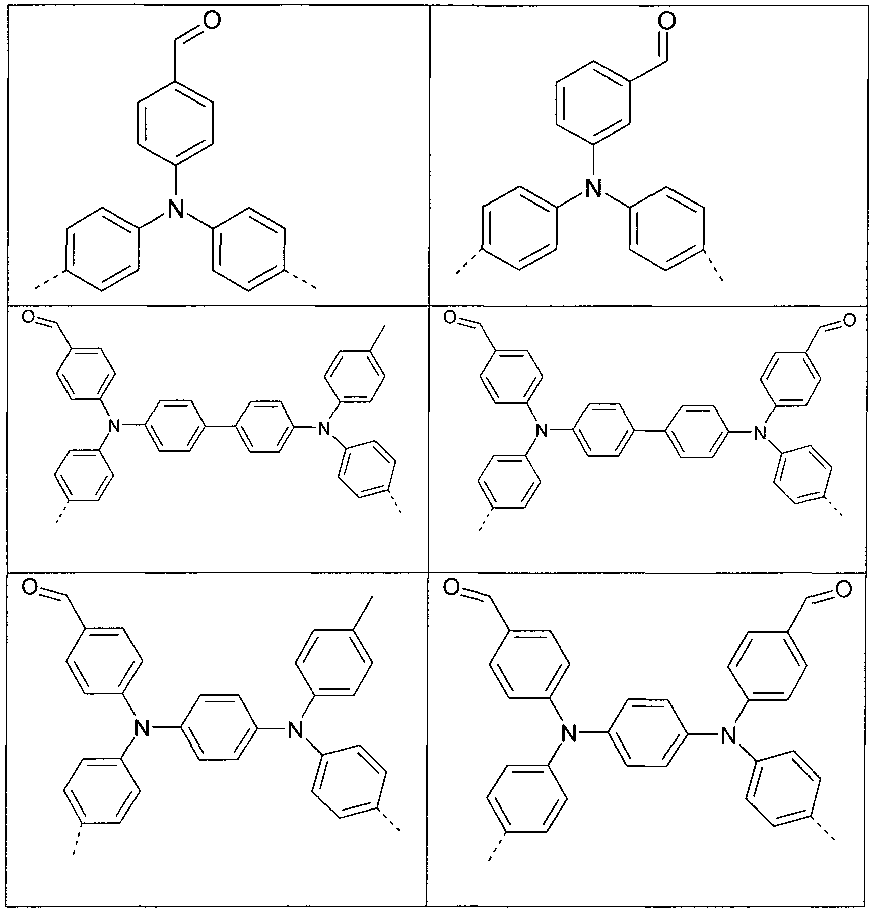

wobei die gestrichelten Linien eine Bindung zu einer weiteren Struktureinheit im Polymer darstellen. Die aromatischen Gruppen können darüber hinaus mit einem oder mehreren Substituenten susbstituiert sein.

Die erfindungsgemäßen Polymere enthaltend Struktureinheiten der Formel (I) und/oder (II), welche eine oder mehrere Aldehydgruppen enthalten, werden in der Regel durch Polymerisation von einer oder mehreren Monomersorten hergestellt, von denen mindestens ein Monomer im Polymer zu Struktureinheiten der Formel (I) und/oder (II) führt. Geeignete Polymerisationsreaktionen sind dem Fachmann bekannt und in der Literatur beschrieben. Besonders geeignete und bevorzugte Polymerisationsreaktionen, die zu C-C- bzw.

C-N-Verknüpfungen führen, sind folgende:
- (A): SUZUKI-Polymerisation;
- (B): YAMAMOTO-Polymerisation;
- (C): STILLE-Polymerisation;
- (D): HECK-Polymerisation;
- (E): NEGISHI-Polymerisation;
- (F): SONOGASHIRA-Polymerisation;
- (G): HIYAMA-Polymerisation; und
- (H): HARTWIG-BUCHWALD-Polymerisation.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 03/048225 A2, der WO 2004/037887 A2 und der WO 2004/037887 A2 im Detail beschrieben.

Die C-C-Verknüpfungen sind vorzugsweise ausgewählt aus den Gruppen der SUZUKI-Kupplung, der YAMAMOTO-Kupplung und der STILLE-Kupplung; die C-N-Verknüpfung ist vorzugsweise eine Kupplung gemäß HARTWIG-BUCHWALD.

Gegenstand der vorliegenden Erfindung ist somit auch ein Verfahren zur Herstellung der erfindungsgemäßen Polymere, das dadurch gekennzeichnet ist, dass sie durch Polymerisation gemäß SUZUKI, Polymerisation gemäß YAMAMOTO, Polymerisation gemäß STILLE oder Polymerisation gemäß HARTWIG-BUCHWALD hergestellt werden.

Monomere, die durch Polymerisation zu den erfindungsgemäßen Polymeren umgesetzt werden können, sind Monomere die an zwei Enden jeweils eine Gruppe enthalten, die unabhängig voneinander aus der Gruppe ausgewählt sind, die aus Halogen, vorzugsweise Br und I, O-Tosylat, O-Triflat, O-SO₂R¹, B(OR¹)₂ und Sn(R¹)₃ besteht.

R¹ ist vorzugsweise bei jedem Auftreten unabhängig voneinander aus der Gruppe ausgewählt, die aus Wasserstoff, einem aliphatischen Kohlenwasserstoffrest mit 1 bis 20 C-Atomen und einem aromatischen mono- oder polycyclischen Ringsystem mit 6 bis 20 Ringatomen besteht, wobei zwei oder mehrere Reste R¹ miteinander ein Ringsystem bilden können. Hierbei sind aliphatische Kohlenwasserstoffe mit 1 bis 20 Kohlenstoffatomen lineare, verzweigte oder cyclische Alkylgruppen, Alkenylgruppen, Alkinylgruppen, bei denen ein oder mehr Kohlenstoffatome durch O, N oder S ersetzt sein können. Zudem kann ein oder mehrere Wasserstoffatome durch Fluor ersetzt sein. Beispiele der aliphatischen Kohlenwasserstoffe mit 1 bis 20 Kohlenstoffatomen schließen die folgenden ein: Methyl, Ethyl, n-Propyl, iso-Propyl, n-Butyl, iso-Butyl, sec-Butyl (1-Methylpropyl), tert-Butyl, iso-Pentyl, n-Pentyl, tert-Pentyl (1,1-Dimethylpropyl), 1,2-Dimethylpropyl, 2,2-Dimethylpropyl (Neopentyl), 1-Ethylpropyl, 2-Methylbutyl, n-Hexyl, iso-Hexyl, 1,2-Dimethylbutyl, 1-Ethyl-1-methylpropyl, 1-Ethyl-2-methylpropyl, 1,1,2-Trimethylpropyl, 1,2,2-Trimethylpropyl, 1-Ethylbutyl, 1-Methylbutyl, 1,1-Dimethylbutyl, 2,2-Dimethylbutyl, 1,3-Dimethylbutyl, 2,3-Dimethylbutyl, 3,3-Dimethylbutyl, 2-Ethylbutyl, 1-Methylpentyl, 2-Methylpentyl, 3-Methylpentyl, Cyclopentyl, Cyclohexyl, Cycloheptyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl und Octinyl.

Der Begriff "mono- oder polycylisches aromatisches Ringsystem mit 6 bis 20 Ringatomen" bezüglich R¹ soll die gleiche Bedeutung haben wie oben definiert, wobei kondensierte aromatische Systeme auch hier bevorzugt sind. Bevorzugte aromatische Ringsysteme sind Naphtyl und Phenyl, wobei Phenyl insbesonders bevorzugt ist.

In dem Fall, dass zwei Reste R¹ ein Ringsystem bilden, stellen diese zwei verknüpften Reste R¹ vorzugsweise eine bivalente aliphatische Gruppe mit 2 bis 8 Kohlenstoffatomen dar. Beispiele hierfür sind Verbindungen der folgenden Formel -CH₂(CH₂)ₙCH₂-, wobei n = 0, 1, 2, 3, 4, 5 oder 6, vorzugsweise 0, 1, 2 oder 3, ist.

In dem Fall, dass mehr als zwei Reste R¹ miteinander ein Ringsystem bilden, stellen diese Reste R¹ miteinander eine verzweigte tri-, tetra-, penta-oder mehrvalente aliphatische Gruppe mit 6 bis 20 Kohlenstoffatomen dar.

In einer besonders bevorzugten Ausführungsform sind die terminierenden Gruppen der Monomere unabhängig voneinander ausgewählt aus Br, I und B(OR¹)₂.

Die erfindungsgemäßen Dendrimere können gemäß dem Fachmann bekannten Verfahren oder in Analogie dazu hergestellt werden. Geeignete Verfahren sind in der Literatur beschrieben, wie z.B. in Frechet, Jean M. J.; Hawker, Craig J., "Hyperbranched polyphenylene and hyperbranched polyesters: new soluble, three-dimensional, reactive polymers", Reactive & Functional Polymers (1995), 26(1-3), 127-36; Janssen, H. M.; Meijer, E. W., "The synthesis and characterization of dendritic molecules", Materials Science and Technology (1999), 20 (Synthesis of Polymers), 403-458; Tomalia, Donald A., "Dendrimer molecules", Scientific American (1995), 272(5), 62-6, WO 02/067343 A1 und WO 2005/026144 A1.

Ein weiterer Gegenstand der vorliegenden Erfindung ist die Verwendung eines Polymers mit Struktureinheiten der Formel (I) und/oder (II), die eine oder mehrere Aldehydgruppen aufweisen, zur Herstellung eines vernetzbaren Polymers. Vorzugsweise ist die vernetzbare Gruppe eine Vinylgruppe oder Alkenylgruppe. Hierbei werden die Aldehydgruppen des Polymers durch WITTIG-Reaktion oder eine WITTIG-analoge Reaktion in Vinylgruppen oder Alkenylgruppen, vorzugsweise Propenylgruppen, umgewandelt.

Gegenstand der vorliegenden Erfindung ist somit auch ein Verfahren, das folgende Schritte umfasst:
(a) Bereitstellen von Polymeren, die Struktureinheiten der Formel (I) und/oder (II) enthalten, die eine oder mehrere Aldehydgruppen aufweisen; und
(b) Umwandlung der Aldehydgruppen in Vinylgruppen oder Alkenylgruppen.

In dem genannten erfindungsgemäßen Verfahren findet die chemische Umwandlung der Aldehydgruppen in Vinylgruppen oder Alkenylgruppen vorzugsweise durch die WITTIG-Reaktion, eine WITTIG-analoge Reaktion, die Emmons-Horner-Reaktion, die Peterson Reaktion oder die Tebbe Methylenierung statt.

Die erfindungsgemäßen Polymere können, unabhängig davon, ob sie noch Aldehydgruppen oder bereits Vinyl- oder Alkenylgruppen enthalten, als Reinsubstanz, aber auch als Mischung zusammen mit weiteren beliebigen polymeren, oligomeren, dendritischen oder niedermolekularen Substanzen verwendet werden. Als niedermolekulare Substanz versteht man in der vorliegenden Erfindung Verbindungen mit einem Molekulargewicht im Bereich von 100 bis 3000 g/mol, vorzugsweise 200 bis 2000 g/mol. Diese weiteren Substanzen können z.B. die elektronischen Eigenschaften verbessern oder selbst emittieren. Als Mischung wird vor- und nachstehend eine Mischung enthaltend mindestens eine polymere Komponente bezeichnet. Auf diese Art können eine oder mehrere Polymerschichten bestehend aus einer Mischung (Blend) aus einem oder mehreren erfindungsgemäßen Polymeren mit einer Struktureinheit der Formel (I) und/oder (II) und optional einem oder mehreren weiteren Polymeren mit einer oder mehreren niedermolekularen Substanzen hergestellt werden.

Ein weiterer Gegenstand der vorliegenden Erfindung ist somit ein Polymer Blend enthaltend ein oder mehrere erfindungsgemäße Polymere, sowie eine oder mehrere weitere polymere, oligomere, dendritische und/oder niedermolekulare Substanzen.

Gegenstand der Erfindung sind weiterhin Lösungen und Formulierungen aus einem oder mehreren erfindungsgemäßen Polymeren oder Mischungen in einem oder mehreren Lösungsmitteln. Wie solche Lösungen hergestellt werden können, ist dem Fachmann bekannt und beispielsweise in der WO 02/072714 A1, der WO 03/019694 A2 und der darin zitierten Literatur beschrieben.

Diese Lösungen können verwendet werden, um dünne Polymerschichten herzustellen, zum Beispiel durch Flächenbeschichtungsverfahren (z.B. Spin-coating) oder durch Druckverfahren (z.B. InkJet Printing).

Polymere enthaltend Struktureinheiten der Formel (I) und/oder (II), welche eine oder mehrere Aldehydgruppen enthalten, eignen sich, nach Umsetzung der Aldehydgruppen zu Alkenyl-, vorzugsweise Vinylgruppen, besonders zur Herstellung von Filmen oder Beschichtungen, insbesondere zur Herstellung von strukturierten Beschichtungen, z.B. durch thermische oder lichtinduzierte in-situ-Polymerisation und in-situ-Vernetzung, wie beispielsweise in-situ-UV-Photopolymerisation oder Photopatterning. Dabei können sowohl entsprechende Polymere in Reinsubstanz verwendet werden, es können aber auch Formulierungen oder Mischungen dieser Polymere wie oben beschrieben verwendet werden. Diese können mit oder ohne Zusatz von Lösungsmitteln und/oder Bindemitteln verwendet werden. Geeignete Materialien, Verfahren und Vorrichtungen für die oben beschriebenen Methoden sind z.B. in der WO 2005/083812 A2 beschrieben. Mögliche Bindemittel sind beispielsweise Polystyrol, Polycarbonat, Poly(meth)acrylate, Polyacrylate, Polyvinylbutyral und ähnliche, optoelektronisch neutrale Polymere.

Geeignete und bevorzugte Lösungsmittel sind beispielsweise Toluol, Anisol, Xylol, Methylbenzoat, Dimethylanisol, Mesitylen, Tetralin, Veratrol, Tetrahydrofuran und Chlorbenzol sowie Gemische derselben.

Ein weiterer Gegenstand der vorliegenden Erfindung ist die Verwendung eines Polymers, das Struktureinheiten der Formel (I) und/oder (II) enthält, die eine oder mehrere Aldehydgruppen aufweisen, zur Herstellung eines vernetzten Polymers. Mit anderen Worten wird die Aldehydgruppe dieses Polymers entweder direkt mit einer Verbindung verknüpft, die entweder schon an ein anderes Polymer bindet oder auf gleiche oder ähnliche Weise an ein weiteres Polymer gebunden werden kann, oder wird in eine vernetzbare Gruppe umgewandelt, die anschließend mit weiteren vernetzbaren Gruppen reagiert, wobei ein vernetztes Polymer entsteht. Die vernetzbare Gruppe ist vorzugsweise eine Vinylgruppe oder Alkenylgruppe und wird vorzugsweise durch die WITTIG-Reaktion oder eine WITTIG-analoge Reaktion in das Polymer eingebaut. Ist die vernetzbare Gruppe eine Vinylgruppe oder Alkenylgruppe, so kann die Vernetzung durch radikalische oder ionische Polymerisation stattfinden, wobei diese thermisch oder durch Strahlung induziert werden kann. Bevorzugt ist die radikalische Polymerisation, die thermisch induziert wird, vorzugsweise bei Temperaturen von weniger als 250°C, besonders bevorzugt bei Temperaturen von weniger als 200°C.

Wahlweise wird während des Vernetzungsverfahrens ein zusätzliches Styrol-Monomer zugesetzt, um einen höheren Grad der Vernetzung zu erzielen. Vorzugsweise ist der Anteil des zugesetzten Styrol-Monomers im Bereich von 0,01 bis 50 mol%, besonders bevorzugt 0,1 bis 30 mol%, bezogen auf 100 mol% aller copolymerisierten Monomere, die im Polymer als Struktureinheiten enthalten sind.

Gegenstand der vorliegenden Erfindung ist somit auch ein Verfahren zur Herstellung eines vernetzten Polymers, das folgende Schritte umfasst:
(a) Bereitstellen von Polymeren, die Struktureinheiten der Formel (I) und/oder (II) enthalten, die eine oder mehrere Aldehydgruppen aufweisen;
(b) Umwandlung der Aldehydgruppen in Vinylgruppen oder Alkenylgruppen; und
(c) Radikalische oder ionische Vernetzung, vorzugsweise radikalische Vernetzung, die sowohl thermisch als auch durch Strahlung, vorzugsweise thermisch, induziert werden kann.

Die durch das erfindungsgemäße Verfahren hergestellten vernetzten Polymere sind in allen gängigen Lösungsmitteln unlöslich. Auf diese Weise lassen sich definierte Schichtdicken herstellen, die auch durch das Aufbringen nachfolgender Schichten nicht wieder gelöst bzw. angelöst werden.

Die vorliegende Erfindung betrifft somit auch ein vernetztes Polymer, das durch das zuvor genannte Verfahren erhältlich ist. Das vernetzte Polymer wird - wie vorstehend beschrieben - vorzugsweise in Form einer vernetzen Polymerschicht hergestellt. Auf die Oberfläche einer solchen vernetzten Polymerschicht kann aufgrund der Unlöslichkeit des vernetzten Polymers in sämtlichen Lösungsmitteln eine weitere Schicht eines erfindungsgemäßen Polymers, das eine Struktureinheit der Formel (I) und/oder (II) enthält, aus einem Lösungsmittel mit den oben beschriebenen Techniken aufgebracht werden.

Die vorliegende Erfindung umfasst auch eine sogenannte Hybridvorrichtung, in der eine oder mehrere Polymerschichten und Schichten, die durch Aufdampfen von niedermolekularen Substanzen hergestellt werden, vorkommen können.

Das erfindungsgemäße vernetzte Polymer kann in elektronischen oder optoelektronischen Vorrichtungen bzw. zu deren Herstellung verwendet werden.

Ein weiterer Gegenstand der vorliegenden Erfindung ist somit die Verwendung des erfindungsgemäßen vernetzten Polymers in elektronischen oder optoelektronischen Vorrichtungen, vorzugsweise in organischen bzw. polymeren organischen Elektrolumineszenzvorrichtungen (OLED, PLED), organischen Feld-Effekt-Transistoren (OFETs), organischen integrierten Schaltungen (O-ICs), organischen Dünnfilmtransistoren (TFTs), organischen Solarzellen (O-SCs), organischen Laserdioden (O-Laser), organischen photovoltaischen (OPV) Elementen oder Vorrichtungen oder organischen Photorezeptoren (OPCs), besonders bevorzugt in organischen bzw. polymeren organischen Elektrolumineszenzvorrichtungen (OLED, PLED), insbesondere in polymeren organischen Elektrolumineszenzvorrichtungen (PLED).

Im Fall der zuvor genannten Hybridvorrichtung spricht man in Verbindung mit organischen Elektrolumineszenzvorrichtungen von kombinierten PLED/SMOLED (Small Molecule Organic Light Emitting Diode) Systemen.

Wie OLEDs bzw. PLEDs hergestellt werden können, ist dem Fachmann bekannt und wird beispielsweise als allgemeines Verfahren ausführlich in der WO 2004/070772 A2 beschrieben, das entsprechend für den Einzelfall anzupassen ist.

Wie oben beschrieben, eignen sich die erfindungsgemäßen Polymeren ganz besonders als Elektrolumineszenzmaterialien in derart hergestellten PLEDs oder Displays.

Als Elektrolumineszenzmaterialien im Sinne der vorliegenden Erfindung gelten Materialien, die als aktive Schicht Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Ein bevorzugter Gegenstand der vorliegenden Erfindung ist daher auch die Verwendung des erfindungsgemäßen vernetzten Polymers in einer PLED, insbesondere als Elektrolumineszenzmaterial.

Gegenstand der vorliegenden Erfindung sind ferner elektronische oder optoelektronische Bauteile, vorzugsweise organische bzw. polymere organische Elektrolumineszenzvorrichtungen (OLED, PLED), organische Feld-Effekt-Transistoren (OFETs), organische integrierte Schaltungen (O-ICs), organische Dünnfilmtransistoren (TFTs), organische Solarzellen (O-SCs), organische Laserdioden (O-Laser), organische photovoltaische (OPV) Elemente oder Vorrichtungen und organische Photorezeptoren (OPCs), besonders bevorzugt organische bzw. polymere organische Elektrolumineszenzvorrichtungen, insbesondere polymere organische Elektrolumineszenzvorrichtungen, mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht, eine Ladungstransportschicht und/oder eine Ladungsinjektionsschicht sein.

Im vorliegenden Anmeldungstext und auch in den im Weiteren folgenden Beispielen wird hauptsächlich auf die Verwendung der erfindungsgemäßen Polymeren in Bezug auf PLEDs und entsprechende Displays abgezielt. Trotz dieser Beschränkung der Beschreibung ist es für den Fachmann ohne weiteres erfinderisches Zutun möglich, die erfindungsgemäßen Polymere als Halbleiter auch für die weiteren, oben beschriebenen Verwendungen in anderen elektronischen Vorrichtungen zu benutzen.

Die folgenden Beispiele sollen die Erfindung erläutern, ohne sie einzuschränken. Insbesondere sind die darin beschriebenen Merkmale, Eigenschaften und Vorteile der dem betreffenden Beispiel zu Grunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Beispiele:

### Beispiel 1:

Herstellung eines Monomers, das zur Herstellung eines erfindungsgemäßen Interlayer Polymers verwendet wird.

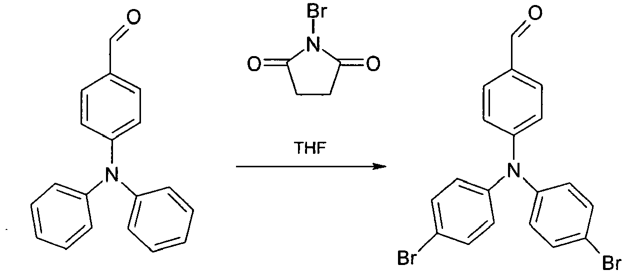

5 g 4-(N,N-Diphenylamino)benzaldehyd (18,3 mmol) werden in 270 ml getrocknetem THF gelöst und auf 0°C abgekühlt. 6,5 g N-Bromsuccinimid (36,6 mmol) werden als Feststoff sukzessive zugegeben und die Lösung bei 0°C 4 Stunden rühren gelassen.

Der Feststoff wird filtriert und die Lösung mit Wasser und Dichlormethan versetzt. Die Phasen werden getrennt. Die organische Phase wird dreimal mit Wasser gewaschen und über Na₂SO₄ getrocknet, dann filtriert und einrotiert. Das Produkt wird mehrmals in Heptan/Toluol umkristallisiert.

¹H NMR (CDCl₃, δ (ppm), *J* (Hz)): 7,02 (d, 4H, J = 8,8), 7,04 (d, 2H, J = 8,8), 7,44 (d, 4H, J = 8,9), 7,71 (d, 2H, J = 8,8), 9,84 (s, 1 H)

### Beispiel 2:

Herstellung eines Monomers, das zur Herstellung eines erfindungsgemäßen Matrix Polymers verwendet wird.

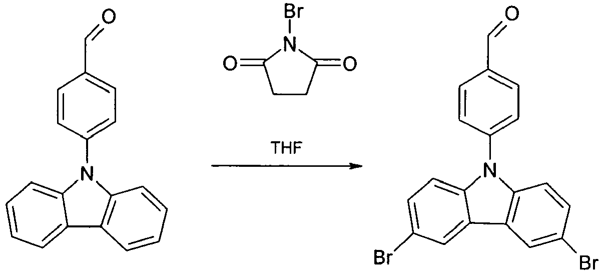

4,9 g N-(4-Formylphenyl)carbazol (18,1 mmol) werden in 270 ml getrocknetem THF gelöst und auf 0°C abgekühlt. 6,4 g N-Bromsuccinimid (36,1 mmol) werden als Feststoff sukzessive zugegeben und die Lösung bei 0°C 4 Stunden rühren gelassen.

Der Feststoff wird filtriert und die Lösung mit Wasser und Dichlormethan versetzt. Die Phasen werden getrennt. Die organische Phase wird dreimal mit Wasser gewaschen und über Na₂S0₄ getrocknet, dann filtriert und einrotiert. Das Produkt wird mehrmals in Ethylacetat umkristallisiert.

¹H NMR (C₂D₂Cl₄, δ (ppm), *J* (Hz)): 7,34 (d, 2H, J = 8,6), 7,55 (d, 2H, J = 8,8), 7,71 (d, 2H, J = 8,3), 8,13 (d, 2H, J = 8,6), 8,21 (s, 2H), 10,10 (s, 1 H)

### Beispiel 3a:

Herstellung der erfindungsgemäßen Polymere P1a, P1b und P1c sowie P2a, P2b und P2c unter Verwendung der in den Beispielen 1 und 2 hergestellten Monomere.

Die erfindungsgemäßen Polymere P1 und P2 werden durch SUZUKI-Kupplung gemäß dem in der WO 03/048225 beschriebenen Verfahren aus den drei nachstehend gezeigten, verschiedenen Struktureinheiten hergestellt. Die auf diese Weise hergestellten Polymere P1a, P1b und P1c sowie P2a, P2b und P2c enthalten die drei Struktureinheiten nach Abspaltung der Abgangsgruppen in den angegebenen prozentualen Anteilen (Prozentangaben = mol%).

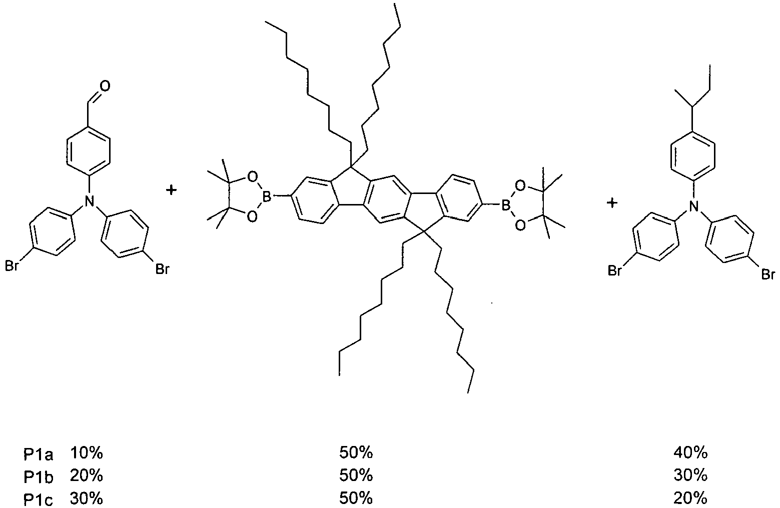

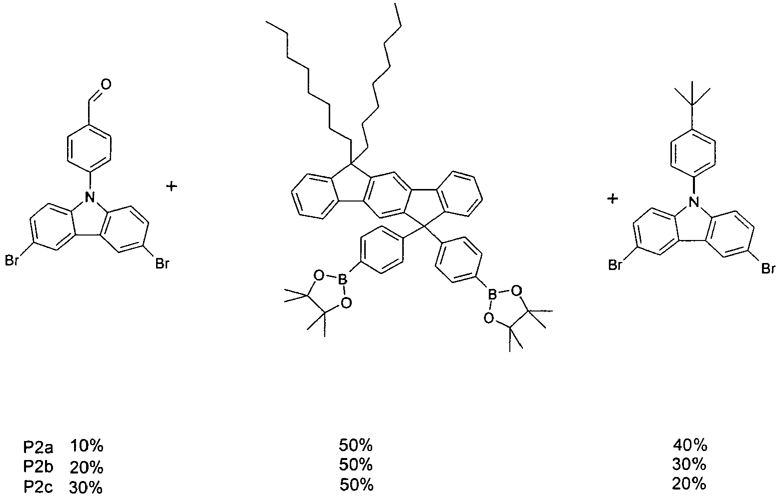

### Beispiel 3b:

Herstellung von Vergleichspolymeren V1 und V2 nach dem gleichen Verfahren wie in Beispiel 3a beschrieben, das die nachstehend gezeigten beiden Struktureinheiten nach Abspaltung der Abgangsgruppen in den angegebenen prozentualen Anteilen enthält (Prozentangaben = mol%):

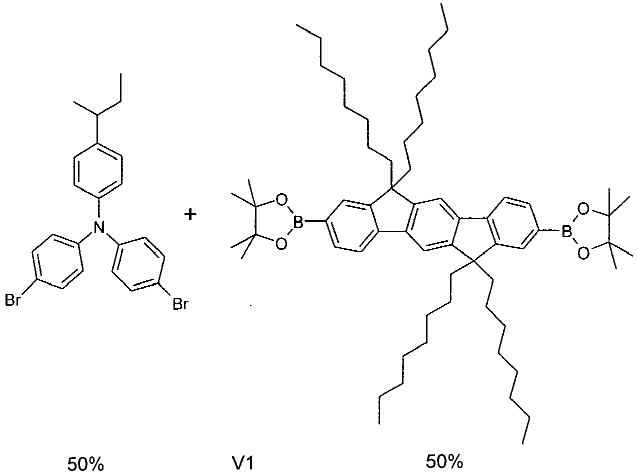

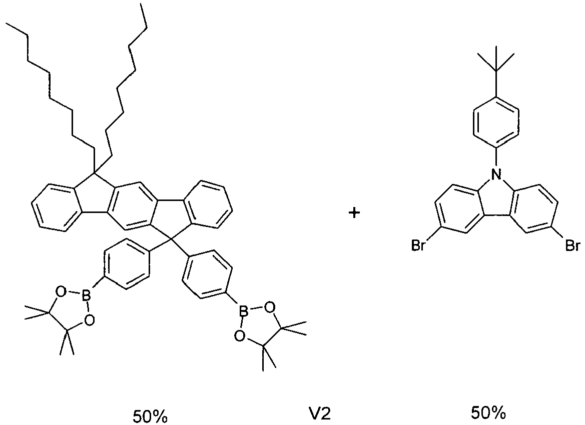

### Beispiel 4:

Einfügen der vernetzbaren Gruppen in die gemäß Beispiel 3a hergestellten Polymere P1 und P2.

Die Polymere P1a', P1b' und P1c' sowie P2a', P2b' und P2c' mit vernetzbaren Gruppen werden aus den gemäß Beispiel 3a hergestellten Polymeren P1a, P1b und P1c sowie P2a, P2b und P2c durch Wittigreaktion gemäß den folgenden Reaktionsschemata hergestellt:

### Wittigreaktion von P1:

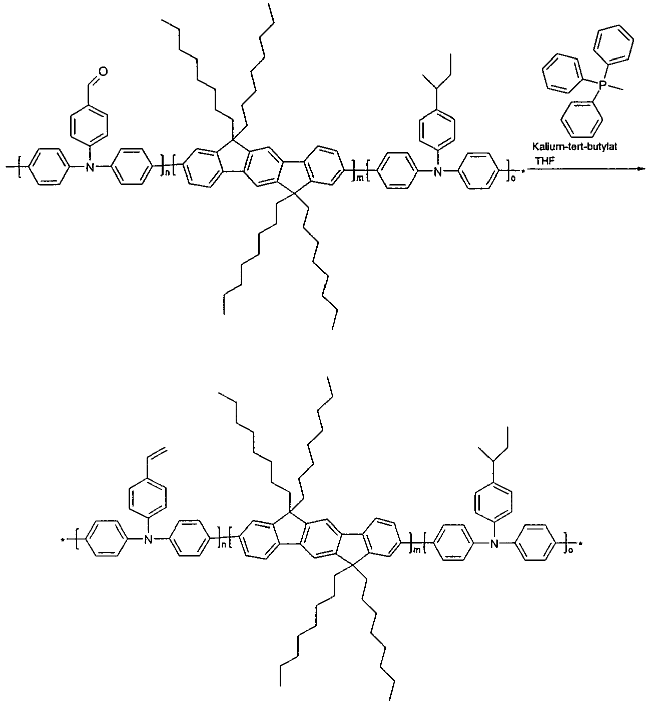

### Wittigreaktion von P2:

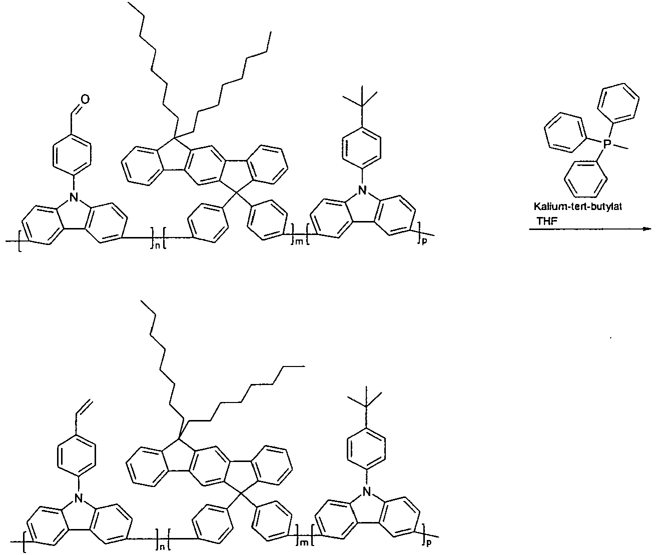

Dazu wird das Polymer P1a (1 g) in 20 ml getrocknetem THF bei 50°C unter Argon aufgelöst und anschließend auf Raumtemperatur abgekühlt. 2,86 g (8 mmol) Methyltriphenylphosphoniumbromid werden in 20 ml getrocknetem THF unter Argon bei 0°C gelöst und 0,90 g (8 mmol) Kaliumtert-butylat portionsweise bei 0°C zugegeben. Anschließend wird die Polymerlösung bei 2°C mit einer Spritze langsam zugegeben und über Nacht bei Raumtemperatur rühren gelassen. Die Lösung wird dreimal mit Wasser extrahiert und die organische Phase in Methanol gefällt.

Analog werden die Polymere P1b und P1 c sowie P2a, P2b und P2c umgesetzt.

### Beispiel 5:

Herstellung einer grün emittierenden PLED mit den Vergleichspolymeren V1 und V2 aus Beispiel 3b.

Die Herstellung einer polymeren Leuchtdiode wird in der Patentliteratur bereits vielfach beschrieben (siehe z.B. WO 2004/037887). Um die vorliegende Erfindung beispielhaft zu erläutern, wird eine PLED gemäß dem in der WO 2004/037887 beschriebenen Verfahren mit dem Vergleichspolymer V1 durch Spincoating auf zuvor mit PEDOT beschichtetem ITO-Substrat hergestellt.(PEDOT ist ein Polythiophen-Derivat (Baytron P, von H. C. Starck, Goslar)). Das beschichtete Substrat wird 10 Minuten bei 180°C ausgeheizt. Die Schichtdicke der so erhaltenen Interlayer beträgt 20 nm. Dann werden 80 nm einer emittierenden Schicht bestehend aus einer Polymermatrix V2 und einem grün phosphoreszierenden Triplett-Emitter T1 (ca. 20 mol%) durch Spincoating aufgebracht. Danach wird eine Ba/Al-Kathode (Metalle von Aldrich) aufgedampft, die PLED verkapselt und elektrooptisch charakterisiert. Tabelle 1 zeigt die erhaltenen Ergebnisse.

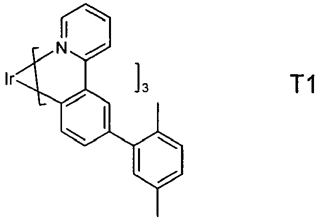

### Beispiel 6:

Herstellung verschiedener grün emittierender PLEDs mit vernetzten Polymerschichten unter Verwendung der Polymere P1a' sowie P2a', P2b' und P2c' aus Beispiel 3a.

Die Herstellung erfolgt wie in Beispiel 5 beschrieben, wobei anstatt des Vergleichspolymers V1 das Polymere P1a' und anstatt des Vergleichspolymers V2 die Polymere P2a', P2b' und P2c' verwendet werden. Nach dem Spincoating wird im Fall von P1' und P2' noch jeweils eine Stunde bei 180°C ausgeheizt, um die Polymere zu vernetzen. Die Schichtdicke der Interlayer aus dem Polymer P1a' beträgt 20 nm und die Schichtdicke der emittierenden Schicht aus den Polymeren V2, P2a', P2b' und P2c' beträgt jeweils 80 nm. Die elektrooptische Charakterisierung der PLEDs erfolgt wie in Beispiel 5 und ist im Folgenden beschrieben. Die Ergebnisse sind in Tabelle 1 zusammengefasst.

### Elektrooptische Charakterisierung:

Für die elektrooptische Charakterisierung werden die in den Beispielen 5 und 6 hergestellten PLEDs in für die Substratgröße eigens angefertigte Halter eingespannt und mittels Federkontakten kontaktiert. Eine Photodiode mit Augenverlaufsfilter kann direkt auf den Messhalter aufgesetzt werden, um Einflüsse von Fremdlicht auszuschließen.

Typischerweise werden die Spannungen von 0 bis max. 20 V in 0,2 V-Schritten erhöht und wieder erniedrigt. Für jeden Messpunkt wird der Strom durch die PLED sowie der erhaltene Photostrom von der Photodiode gemessen. Auf diese Art und Weise erhält man die IVL-Daten der Test-PLED. Wichtige Kenngrößen sind die gemessene maximale Effizienz ("Eff." in cd/A) und die für 100 cd/m² benötigte Spannung U₁₀₀.

Um außerdem die Farbe und das genaue Elektrolumineszenzspektrum der Test-PLED zu kennen, wird nach der ersten Messung nochmals die für 100 cd/m² benötigte Spannung angelegt und die Photodiode durch einen Spektrum-Messkopf ersetzt. Dieser ist durch eine Lichtleitfaser mit einem Spektrometer (Ocean Optics) verbunden. Aus dem gemessenen Spektrum können die Farbkoordinaten (CIE: Commission International de l'éclairage, Normalbetrachter von 1931) abgeleitet werden.

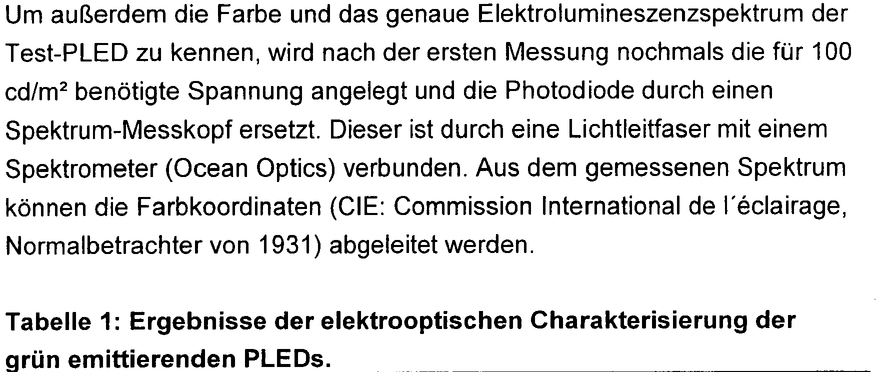

**Tabelle 1: Ergebnisse der elektrooptischen Charakterisierung der grün emittierenden PLEDs.**

| Interlayer-Polymer | Matrix-Polymer | Max.Eff [cd/A] | U@100cd/m² [V] | CIE [x/y] |
|---|---|---|---|---|
| V1 | V2 | 15,0 | 9,1 | 0,35/0,61 |
| P1a' | V2 | 15,2 | 9,7 | 0,34/0,62 |
| P1a' | P2a' | 15,4 | 9,5 | 0,35/0,63 |
| P1a' | P2b' | 14,7 | 9,3 | 0,35/0,62 |
| P1a' | P2c' | 14,5 | 9,5 | 0,36/0,61 |

Die Effizienz der PLEDs mit vernetzten Interlayer- und/oder Matrix-Polymeren P1a' und P2a-c' ist vergleichbar mit der Effizienz der PLED mit nicht vernetzten Vergleichspolymeren V1 und V2. Spannung und Farbkoordinaten sind ebenfalls vergleichbar. Dies zeigt, dass die Vernetzung keine negativen Auswirkungen auf Effizienz, Spannung und Farbkoordinaten hat. Ein großer Vorteil ist jedoch, dass die Vernetzung der erfindunsgemäßen Polymeren es erlaubt, die Schichtdicke gezielt zu variieren und genau zu kontrollieren, da die vernetzte Schicht nicht mehr angelöst und abgewaschen werden kann, was in Beispiel 8 genauer erläutert wird. So wird ein Mehrschichtaufbau in einer PLED realisiert, bei dem alle Schichten aus Lösung prozessiert werden und eine definierte Schichtdicke aufweisen. Im vorliegenden Fall ist es z. B. auch möglich auf die vernetzte grün emittierende Schicht (P2' mit 20 mol% T1) noch eise dritte Schicht definierte Schichtdicke aufzubringen bevor die Kathode aufgedampft und die PLED verkapselt wird. Ist die dritte Schicht ebenfalls vernetzbar, kann eine vierte Schicht definierter Schichtdricke aufgebracht werden.

### Beispiel 7:

Herstellung verschiedener blau emittierender PLEDs unter Verwendung der Polymeren P1a', P1b' und P1c' und deren Vernetzung.

Die Herstellung erfolgt anaolg zu Beispiel 5 und 6. Die Polymere V1, P1a', P1b' und P1c' werden durch Spincoating auf zuvor mit PEDOT beschichtete ITO-Substrate aufgebracht. Anschließend werden die mit P1a', P1b' und P1c' beschichteten Substrate jeweils eine Stunde bei 180°C ausgeheizt, um die Polymere zu vernetzen. Die Dicke der Polymerschicht beträgt jeweils 20 nm. Dann wird eine 65 nm dicke Schicht eines blauemittierenden Polymeren B1 durch Spincoating aufgebracht. (Die Herstellung von B1 erfolgt analog Beispiel 3. B1 enthält die nachstehend gezeigten Struktureinheiten nach Abspaltung der Abgangsgruppen in den angegebenen prozentualen Anteilen (Prozentangaben = mol%))

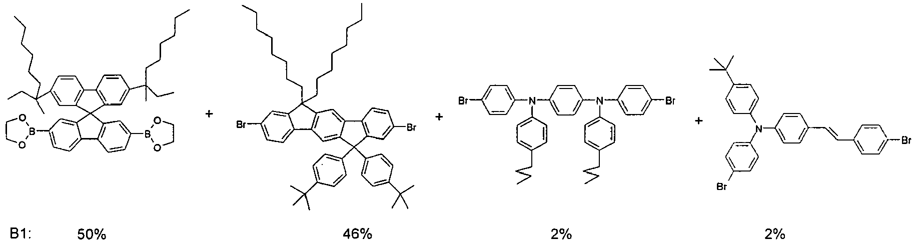

Anschließend wird eine Ba/Al-Kathode aufgedampft und die PLED verkapselt. Die elektrooptische Charakterisierung der PLED erfolgt wie in Beispiel 6 beschrieben. Die Ergebnisse sind in Tabelle 2 zusammengefasst.

**Tabelle 2: Ergebnisse der elektrooptischen Charakterisierung der blau emittierenden PLEDs.**

| Interlayer-Polymer | Max.Eff [cd/A] | U@100cd/m² [V] | CIE [x/y] |
|---|---|---|---|
| V1 | 6,04 | 2,9 | 0,15/0,23 |
| P1a' | 5,92 | 2,8 | 0,15/0,23 |
| P1b' | 5,68 | 2,9 | 0,15/0,26 |
| P1c' | 5,69 | 2,9 | 0,15/0,24 |

Die Effizienz der PLEDs mit vernetzten Polymeren P1a', P1b' und P1c' ist vergleichbar mit der des nicht vernetzten Vergleichspolymers V1. Spannung und Farbkoordinaten sind ebenfalls vergleichbar. Dies zeigt, dass die Vernetzung der Interlayer keine negativen Auswirkungen auf Effizienz, Spannung und Farbkoordinaten der PLED hat. Ein großer Vorteil ist jedoch, dass die Vernetzung der erfindungsgemäßen Polymeren es erlaubt, die Schichtdicke gezielt zu variieren und genau zu kontrollieren, da die vernetzte Schicht nicht mehr angelöst und abgewaschen werden kann, was in Beispiel 8 genauer erläutert wird. So wird ein Mehrschichtaufbau aus mindestens zwei Schichten in einer aus Lösung prozessierten PLED realisiert, bei dem die Schichten eine definierte Schichtdicke aufweisen.

### Beispiel 8:

### Kontrolle der Schichtdicken

Die Polymere V1, V2, P1a', P1b', P1c', P2a', P2b' und P2c' werden durch Spincoating mit Schichtdicken wie in Tabelle 2 beschrieben auf Glasträger aufgeschleudert. Die Schichtdicke wird gemessen, indem man die Polymerschicht mit einer Nadel ankratzt, wobei der Kratzer bis auf das Glassubstrat hinunter geht. Anschließend wird die Tiefe des Kratzers und damit die Polymerschichtdicke an mindestens zwei Stellen je zweimal mit Hilfe einer AFM-Nadel (Atomic Force Microscopy) gemessen und der Mittelwert gebildet (Tabelle 3). Im Fall der erfindungsgemäßen Polymere P1' und P2' wird der Polymerfilm eine Stunde bei 180°C ausgeheizt, um zu vernetzen. Im Fall des Vergleichspolymeren V1 und V2 wird der Polymerfilm 10 Minuten bei 180°C ausgeheizt. Dann werden alle Polymerfilme eine Minute mit Toluol auf dem Spincoater gewaschen (Umdrehungsgeschwindigkeit 1000 U/min) und der Film noch einmal 10 Minuten bei 180°C ausgeheizt, um das Lösungsmittel zu entfernen. Anschließend wird die Schichtdicke noch einmal wie oben beschrieben gemessen, um zu überprüfen, ob sich die Schichtdicke verändert hat (Tabelle 3). Verringert sich die Schichtdicke nicht, so ist das Polymer unlöslich und somit die Vernetzung ausreichend.

**Tabelle 3: Schichtdickenmessungen an vernetzten und unvernetzten Polymeren vor und nach Waschen mit Toluol.**

| Polymer | Gemessene Schichtdicke vor Vernetzung* und Waschprozess (nm) | Gemessene Schichtdicke nach Vernetzung* und Waschprozess (nm) | Verbliebene Schichtdicke nach Vernetzung* und Waschprozess [%] |
|---|---|---|---|
| P1a' | 20 | 19 | 95 |
| P1a' | 39 | 33 | 85 |
| P1b' | 21 | 20 | 95 |
| P1c' | 20 | 19 | 95 |
| P1c' | 43 | 40 | 93 |
| P2a' | 80 | 70 | 88 |
| P2b' | 80 | 73 | 92 |
| P2c' | 80 | 76 | 95 |
| V1 | 20 | 4 | 20 |
| V1 | 40 | 5 | 13 |
| V2 | 80 | 5 | 6 |

| | | | |
|---|---|---|---|
| * Vernetzung nur bei P1 a-c' und P2a-c' | | | |

Die Ergebnisse zeigen, dass das Vernetzen der erfindungsgemäßen Polymere nahezu quantitativ ist. Je höher der Anteil der Vernetzungsgruppen ist, desto unlöslicher das Polymer nach der Vernetzung. Bei geringer Schichtdicke von 20 nm sind bereits 10% vernetzbarer Monomeranteil im Polymer ausreichend, damit die Schicht ausreichend vernetzt und nicht heruntergewaschen wird. Es verbleiben 95% der ursprünglich aufgebrachten Schichtdicke (P1') im Vergleich zu 20% mit einem nicht vernetzbaren Polymer (V1). Bei Schichtdicken von 80 nm zeigt ein Anteil von 10% vernetzbaren Monomereinheiten im Polymer bereits eine deutliche Verbesserung. Es verbleiben nach dem Waschen ca. 88% der Schichtdicke des vernetzten Polymers (P2a') statt 6% bei dem entsprechenden nicht vernetzbaren Polymer (V2). Mit ≥ 20% vernetzbarer Monomereinheit im Polymer verbleiben > 90% der ursprünglich aufgebrachten Schichtdicke (P2b', P2c'). Mit den erfindungsgemäßen, vernetzbaren Polymeren ist es also möglich, die Schichtdicke zu kontrollieren.

## Patentansprüche

1. Polymer, enthaltend 1 bis 30 mol% Struktureinheiten der folgenden Formel (I): 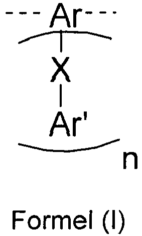 **dadurch gekennzeichnet, dass** zumindest ein Vertreter aus Ar und Ar' eine Aldehydgruppe aufweist,
wobei die verwendeten Symbole und Indices die folgenden Bedeutungen haben:
Ar und Ar' stellen unabhängig voneinander ein substituiertes oder unsubstituiertes, mono- oder polycyclisches, aromatisches oder heteroaromatisches Ringsystem dar, wobei ein substituiertes oder unsubstituiertes, mono- oder polycyclisches, aromatisches Ringsystem ein Ringsystem mit 6 bis 60 aromatischen Ringatomen bedeutet, das nicht notwendigerweise nur aromatische Gruppen enthält, sondern in dem auch mehrere aromatische Einheiten durch eine kurze nicht-aromatische Einheit, ausgewählt aus sp³-hybridisiertem C-Atom, bzw. O- oder N-Atom sowie CO-Gruppe, unterbrochen sein können, und wobei ein substituiertes oder unsubstituiertes, mono- oder polycyclisches, heteroaromatisches Ringsystem ein Ringsystem mit 5 bis 60 aromatischen Ringatomen bedeutet, wobei ein oder mehrere dieser Atome ein Heteroatom ist/sind, das nicht notwendigerweise nur aromatische Gruppen enthält, sondern in dem auch mehrere aromatische Gruppen durch eine kurze nichtaromatische Einheit, ausgewählt aus sp³-hybridisiertem C-Atom, bzw. O- oder N-Atom sowie CO-Gruppe, unterbrochen sein können;
X stellt eine kovalente Einfachbindung oder eine geradkettige, verzweigte oder cyclische C₁₋₁₀-Alkylen-, C₁₋₁₀-Alkenylen- oder C₁₋₁₀-Alkinylengruppe dar, in der ein oder mehrere H-Atome durch F ersetzt sein können und in der eine oder mehrere CH₂-Gruppen durch O, NH oder S ersetzt sein können; und
n ist 1, 2, 3 oder 4; und
die gestrichelten Linien stellen Bindungen zur nächsten Struktureinheit des Polymers dar,
und weitere Struktureinheiten, die von der Struktureinheit der Formel (I) verschieden sind, ausgewählt aus
- Einheiten, welche typischerweise als Backbone verwendet werden und zusätzlich
- Einheiten, welche die Lochinjektions- und/oder Lochtransporteigenschaften der Polymere erhöhen und/oder
- Einheiten, welche die Elektroneninjektions- und/oder Elektronentransporteigenschaften der Polymere erhöhen,
wobei die Struktureinheiten, die Lochinjektions- und/oder Lochtransporteigenschaften aufweisen, ausgewählt werden aus Triarylamin-, Benzidin-, Tetraaryl-para-phenylen-diamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivaten;
wobei die Struktureinheiten, die Elektroneninjektions- und/oder Elektronentransporteigenschaften aufweisen, ausgewählt werden aus Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivaten sowie Triarylboranen; und wobei die Struktureinheiten, welche typischerweise als Polymergrundgerüst (Backbone) verwendet werden, ausgewählt werden aus 4,5-Dihydropyrenderivaten, 4,5,9,10-Tetrahydropyrenderivaten, Fluorenderivaten, 9,9'-Spirobifluorenderivaten, Phenanthrenderivaten, 9,10-Dihydrophenanthrenderivaten, 5,7-Dihydrodibenzooxepinderivaten und cis- und trans-Indenofluorenderivaten.

2. Polymer nach Anspruch 1, **dadurch gekennzeichnet, dass** Ar' eine substituierte oder unsubstituierte Einheit ist, die aus der Gruppe ausgewählt ist, die aus folgendem besteht:
Phenylen, Biphenylen, Triphenylen, [1,1':3',1"]Terphenyl-2'-ylen, Naphthylen, Anthracen, Binaphthylen, Phenanthren, Dihydrophenanthren, Pyren, Dihydropyren, Chrysen, Perylen, Tetracen, Pentacen, Benzo[a]pyren, Fluoren, Inden, Indenofluoren, Spirobifluoren, Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen und Benzothiadiazothiophen.

3. Polymer nach Anspruch 1 oder 2, **dadurch gekennzeichnet, dass** die Struktureinheit der Formel (I) eine Struktureinheit der folgenden Formel (II) ist: 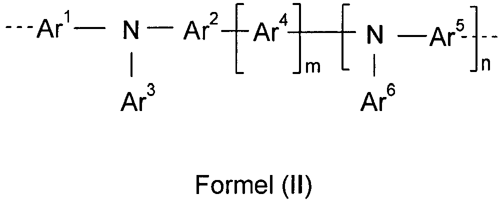 **dadurch gekennzeichnet, dass** zumindest ein Ar der Einheiten Ar¹ bis Ar⁶ eine Aldehydgruppe aufweist,
wobei die verwendeten Symbole und Indices die folgenden Bedeutungen haben:
Ar¹ bis Ar⁶ sind gleich oder verschieden und stellen unabhängig voneinander ein substituiertes oder unsubstituiertes, mono- oder polycyclisches, aromatisches oder heteroaromatisches Ringsystem mit 5 bis 25 Ringatomen dar;
m ist 0 oder 1;
n ist 0, 1 oder 2;
die gestrichelten Linien stellen Bindungen zur nächsten Struktureinheit des Polymers dar;
mit der Maßgabe, dass, wenn n = 1 ist, die beiden N-Atome an verschiedene C-Atome des gleichen aromatischen Ringsystems binden.

4. Polymer nach einem oder mehreren der Ansprüche 1 bis 3, **dadurch gekennzeichnet, dass** Ar der Formel (I) bzw. Ar¹, Ar², Ar⁴ und Ar⁵ der Formel (II) eine substituierte oder unsubstituierte Einheit ist, die aus der Gruppe ausgewählt ist, die aus folgendem besteht:
4,5-Dihydropyren, 4,5,9,10-Tetrahydrofluoren, 9,9'-Spirobifluoren, Fluoren, Phenanthren, 9,10-Dihydrophenanthren, 5,7-Dihydrodibenzooxepin, cis-Indenofluoren, trans-Indenofluoren, Phenylen, Thiophen, Benzanthracen, Carbazol, Benzimidazol, Oxepin und Triazin.

5. Polymer nach Anspruch 1, **dadurch gekennzeichnet, dass** die weitere Struktureinheit eine Struktureinheit der Formel (I) und/oder (II) ist, die keine Aldehydgruppe aufweist.

6. Polymer nach einem oder mehreren der Ansprüche 1 bis 5, **dadurch gekennzeichnet, dass** Ar' in Formel (I) bzw. Ar³ und/oder Ar⁶ in Formel (II) eine Aldehydgruppe aufweist.

7. Polymer nach einem oder mehreren der Ansprüche 3 bis 6, **dadurch gekennzeichnet, dass** die Struktureinheit der Formel (II) ausgewählt ist aus den folgenden Struktureinheiten:

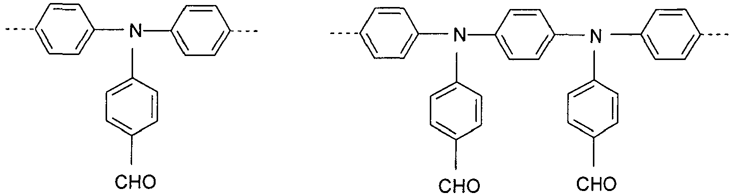

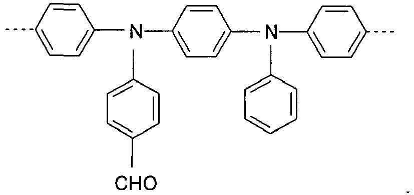

8. Mischung aus einem oder mehreren Polymer(en) nach einem oder mehreren der Ansprüche 1 bis 7 mit weiteren polymeren, oligomeren, dendritischen und/oder niedermolekularen Substanzen.

9. Formulierung aus einem oder mehreren Polymer(en) nach einem oder mehreren der Ansprüche 1 bis 7 oder aus einer Mischung nach Anspruch 8 in einem oder mehreren Lösungsmitteln.

10. Verwendung eines Polymers nach einem oder mehreren der Ansprüche 1 bis 7, zur Herstellung eines vernetzbaren und/oder eines vernetzten Polymers.

11. Verfahren zur Herstellung eines vernetzten Polymers, **dadurch gekennzeichnet, dass** es die folgenden Schritte umfasst:
(a) Bereitstellen von Polymeren nach einem oder mehreren der Ansprüche 1 bis 7, die Aldehydgruppen aufweisen;
(b) Umwandlung der Aldehydgruppen in vernetzbare Vinyl- oder Alkenylgruppen, und
(c) Vernetzen der Polymere mittels der vernetzbaren Vinyl- oder Alkenylgruppen durch radikalische oder ionische Vernetzung.

## Claims

1. Polymer containing 1 to 30 mol% of structural units of the following formula (I): 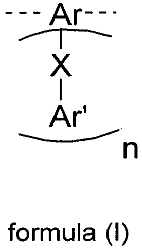 **characterised in that** at least one representative from Ar and Ar' contains an aldehyde group,
where the symbols and indices used have the following meanings:
Ar and Ar' represent, independently of one another, a substituted or unsubstituted, mono- or polycyclic, aromatic or heteroaromatic ring system, where a substituted or unsubstituted, mono- or polycyclic, aromatic ring system denotes a ring system having 6 to 60 aromatic ring atoms, which does not necessarily contain only aromatic groups, but instead in which, in addition, a plurality of aromatic units may be interrupted by a short non-aromatic unit selected from an sp³-hybridised C atom, or an O or N atom, or a CO group, and where a substituted or unsubstituted, mono- or polycyclic, heteroaromatic ring system denotes a ring system having 5 to 60 aromatic ring atoms, where one or more of these atoms is/are a heteroatom, which does not necessarily contain only aromatic groups, but instead in which, in addition, a plurality of aromatic groups may be interrupted by a short non-aromatic unit selected from an sp³-hybridised C atom, or an O or N atom, or a CO group;
X represents a single covalent bond or a straight-chain, branched or cyclic C₁₋₁₀-alkylene, C₁₋₁₀-alkenylene or C₁₋₁₀-alkynylene group, in which one or more H atoms may be replaced by F and in which one or more CH₂ groups may be replaced by O, NH or S; and
n is 1, 2, 3 or 4; and
the dashed lines represent bonds to the next structural unit of the polymer,
and further structural units which are different from the structural unit of the formula (I), selected from
- units which are typically used as backbone and additionally
- units which increase the hole-injection and/or hole-transport properties of the polymers
and/or
- units which increase the electron-injection and/or electron-transport properties of the polymers,
where the structural units which have hole-injection and/or hole-transport properties are selected from triarylamine, benzidine, tetraaryl-para-phenylenediamine, triarylphosphine, phenothiazine, phenoxazine, dihydrophenazine, thianthrene, dibenzo-para-dioxin, phenoxathiyne, carbazole, azulene, thiophene, pyrrole and furan derivatives;
where the structural units which have electron-injection and/or electron-transport properties are selected from pyridine, pyrimidine, pyridazine, pyrazine, oxadiazole, quinoline, quinoxaline, anthracene, benzanthracene, pyrene, perylene, benzimidazole, triazine, ketone, phosphine oxide and phenazine derivatives, and triarylboranes;
and where the structural units which are typically used as polymer backbone are selected from 4,5-dihydropyrene derivatives, 4,5,9,10-tetrahydropyrene derivatives, fluorene derivatives, 9,9'-spirobifluorene derivatives, phenanthrene derivatives, 9,10-dihydrophenanthrene derivatives, 5,7-dihydrodibenzoxepine derivatives and cis- and trans-indenofluorene derivatives.

2. Polymer according to Claim 1, **characterised in that** Ar' is a substituted or unsubstituted unit selected from the group consisting of the following:
phenylene, biphenylene, triphenylene, 1,1':3',1"-terphenyl-2'-ylene, naphthylene, anthracene, binaphthylene, phenanthrene, dihydrophenanthrene, pyrene, dihydropyrene, chrysene, perylene, tetracene, pentacene, benzo[a]pyrene, fluorene, indene, indenofluorene, spirobifluorene, pyrrole, pyrazole, imidazole, 1,2,3-triazole, 1,2,4-triazole, tetrazole, furan, thiophene, selenophene, oxazole, isoxazole, 1,2-thiazole, 1,3-thiazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, pyridine, pyridazine, pyrimidine, pyrazine, 1,3,5-triazine, 1,2,4-triazine, 1,2,3-triazine, 1,2,4,5-tetrazine, 1,2,3,4-tetrazine, 1,2,3,5-tetrazine, indole, isoindole, indolizine, indazole, benzimidazole, benzotriazole, purine, naphthimidazole, phenanthrimidazole, pyridimidazole, pyrazinimidazole, quinoxalinimidazole, benzoxazole, naphthoxazole, anthroxazole, phenanthroxazole, isoxazole, benzothiazole, benzofuran, isobenzofuran, dibenzofuran, quinoline, isoquinoline, pteridine, benzo-5,6-quinoline, benzo-6,7-quinoline, benzo-7,8-quinoline, benzoisoquinoline, acridine, phenothiazine, phenoxazine, benzopyridazine, benzopyrimidine, quinoxaline, phenazine, naphthyridine, azacarbazole, benzocarboline, phenanthridine, phenanthroline, thieno[2,3b]thiophene, thieno[3,2b]thiophene, dithienothiophene, isobenzothiophene, dibenzothiophene and benzothiadiazothiophene.

3. Polymer according to Claim 1 or 2, **characterised in that** the structural unit of the formula (I) is a structural unit of the following formula (II): 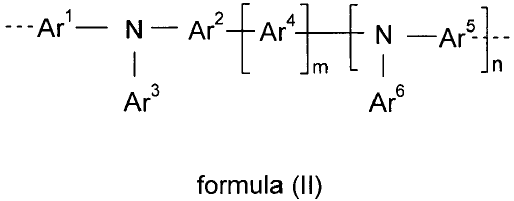 **characterised in that** at least one Ar of the units Ar¹ to Ar⁶ contains an aldehyde group,
where the symbols and indices used have the following meanings:
Ar¹ to Ar⁶ are identical or different and represent, independently of one another, a substituted or unsubstituted, mono- or polycyclic, aromatic or heteroaromatic ring system having 5 to 25 ring atoms;
m is 0 or 1;
n is 0, 1 or 2;
the dashed lines represent bonds to the next structural unit of the polymer;
with the proviso that, if n = 1, the two N atoms are bonded to different C atoms of the same aromatic ring system.

4. Polymer according to one or more of Claims 1 to 3, **characterised in that** Ar in the formula (I) or Ar¹, Ar², Ar⁴ and Ar⁵ in the formula (II) is a substituted or unsubstituted unit selected from the group consisting of the following:
4,5-dihydropyrene, 4,5,9,10-tetrahydrofluorene, 9,9'-spirobifluorene, fluorene, phenanthrene, 9,10-dihydrophenanthrene, 5,7-dihydrodibenzoxepine, cis-indenofluorene, trans-indenofluorene, phenylene, thiophene, benzanthracene, carbazole, benzimidazole, oxepine and triazine.

5. Polymer according to Claim 1, **characterised in that** the further structural unit is a structural unit of the formula (I) and/or (II) which does not contain an aldehyde group.

6. Polymer according to one or more of Claims 1 to 5, **characterised in that** Ar' in formula (I) or Ar³ and/or Ar⁶ in formula (II) contains an aldehyde group.

7. Polymer according to one or more of Claims 3 to 6, **characterised in that** the structural unit of the formula (II) is selected from the following structural units:

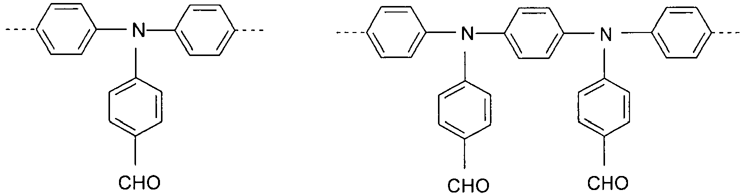

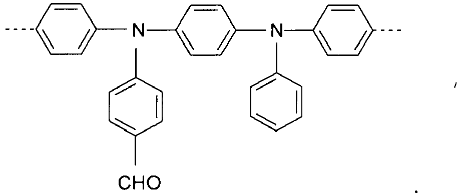

8. Mixture of one or more polymer(s) according to one or more of Claims 1 to 7 with further polymeric, oligomeric, dendritic and/or low-molecular-weight substances.

9. Formulation comprising one or more polymer(s) according to one or more of Claims 1 to 7 or comprising a mixture according to Claim 8 in one or more solvents.

10. Use of a polymer according to one or more of Claims 1 to 7 for the preparation of a crosslinkable and/or crosslinked polymer.

11. Process for the preparation of a crosslinked polymer, **characterised in that** it comprises the following steps:
(a) provision of polymers according to one or more of Claims 1 to 7 which contain aldehyde groups;
(b) conversion of the aldehyde groups into crosslinkable vinyl or alkenyl groups; and
(c) crosslinking of the polymers by means of the crosslinkable vinyl or alkenyl groups by free-radical or ionic crosslinking.

## Revendications

1. Polymère contenant 1 à 30 % en pourcentage molaire d'unités structurelles de la formule (I) qui suit : 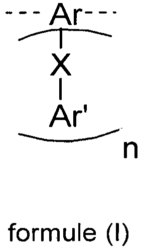 **caractérisé en ce qu'**au moins un représentant pris parmi Ar et Ar' contient un groupe aldéhyde,
formule dans laquelle les symboles et indices utilisés présentent les significations qui suivent :
Ar et Ar' représentent, indépendamment l'un de l'autre, un système de cycle aromatique ou hétéroaromatique monocyclique ou polycyclique substitué ou non substitué, où un système de cycle aromatique monocyclique ou polycyclique substitué ou non substitué représente un système de cycle qui comporte 6 à 60 atomes de cycle aromatique, lequel ne contient pas nécessairement seulement des groupes aromatiques, mais en lieu et place dans lequel, en outre, les unités d'une pluralité d'unités aromatiques peuvent être interrompues par une unité non aromatique courte qui est choisie parmi un atome de C sp³-hybridisé C, ou un atome de O ou de N, ou un groupe CO, et où un système de cycle hétéroaromatique monocyclique ou polycyclique substitué ou non substitué représente un système de cycle qui comporte 5 à 60 atomes de cycle aromatique, où un ou plusieurs de ces atomes est/sont un hétéroatome, lequel ne contient pas nécessairement seulement des groupes aromatiques, mais en lieu et place dans lequel, en outre, des groupes d'une pluralité de groupes aromatiques peuvent être interrompus par une unité non aromatique courte qui est choisie parmi un atome de C sp³-hybridisé, ou un atome de O ou de N, ou un groupe CO ;
X représente une unique liaison covalente ou un groupe C₁₋₁₀-alkylène, C₁₋₁₀-alkénylène ou C₁₋₁₀-alkynylène en chaîne droite, ramifié ou cyclique, où un ou plusieurs atome(s) de H peut/peuvent être remplacé(s) par F et où un ou plusieurs groupe(s) CH₂ peut/peuvent être remplacé(s) par O, NH ou S ; et
n est 1, 2, 3 ou 4 ; et
les lignes en pointillés représentent des liaisons sur l'unité structurelle suivante du polymère,
et d'autres unités structurelles qui sont différentes des unités structurelles de la formule (I), lesquelles sont choisies parmi :
- des unités qui sont de façon typique utilisées en tant que chaîne principale, et de façon additionnelle
- des unités qui augmentent les propriétés d'injection de trous et/ou de transport de trous des polymères
et/ou
- des unités qui augmentent les propriétés d'injection d'électrons et/ou de transport d'électrons des polymères,
où les unités structurelles qui présentent des propriétés d'injection de trous et/ou de transport de trous sont choisies parmi les dérivés de triarylamine, de benzidine, de tétraaryl-para-phénylènediamine, de triarylphosphine, de phénothiazine, de phénoxazine, de dihydrophénazine, de thianthrène, de dibenzo-para-dioxine, de phénoxathiyne, de carbazole, d'azulène, de thiophène, de pyrrole et de furane ;
où les unités structurelles qui présentent des propriétés d'injection d'électrons et/ou de transport d'électrons sont choisies parmi les dérivés de pyridine, de pyrimidine, de pyridazine, de pyrazine, d'oxadiazole, de quinoline, de quinoxaline, d'anthracène, de benzanthracène, de pyrène, de pérylène, de benzimidazole, de triazine, de cétone, d'oxyde de phosphine et de phénazine, et les triarylboranes ;
et où les unités structurelles qui sont de façon typique utilisées en tant que chaîne principale du polymère sont choisies parmi les dérivés de 4,5-dihydropyrène, les dérivés de 4,5,9,10-tétrahydropyrène, les dérivés de fluorène, les dérivés de 9,9'-spirobifluorène, les dérivés de phénanthrène, les dérivés de 9,10-dihydrophénanthrène, les dérivés de 5,7-dihydrodibenzoxépine et les dérivés de cis- et trans-indéno-fluorène.

2. Polymère selon la revendication 1, **caractérisé en ce que** Ar' est une unité substituée ou non substituée choisie parmi le groupe constitué par ce qui suit :
phénylène, biphénylène, triphénylène, 1,1':3',1"-terphényl-2'-ylène, naphtylène, anthracène, binaphtylène, phénanthrène, dihydrophèn-anthrène, pyrène, dihydropyrène, chrysène, pérylène, tétracène, pentacène, benzo[a]pyrène, fluorène, indène, indénofluorène, spirobifluorène, pyrrole, pyrazole, imidazole, 1,2,3-triazole, 1,2,4-triazole, tétrazole, furane, thiophène, sélénophène, oxazole, isoxazole, 1,2-thiazole, 1,3-thiazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, pyridine, pyridazine, pyrimidine, pyrazine, 1,3,5-triazine, 1,2,4-triazine, 1,2,3-triazine, 1,2,4,5-tétrazine, 1,2,3,4-tétrazine, 1,2,3,5-tétrazine, indole, isoindole, indolizine, indazole, benzimidazole, benzotriazole, purine, naphtimidazole, phénanthrimidazole, pyridimidazole, pyrazinimidazole, quinoxalinimidazole, benzoxazole, naphtoxazole, anthroxazole, phénanthroxazole, isoxazole, benzothiazole, benzofurane, isobenzofurane, dibenzofurane, quinoline, isoquinoline, ptéridine, benzo-5,6-quinoline, benzo-6,7-quinoline, benzo-7,8-quinoline, benzoisoquinoline, acridine, phénothiazine, phénoxazine, benzopyridazine, benzopyrimidine, quinoxaline, phénazine, naphtyridine, azacarbazole, benzocarboline, phénanthridine, phénanthroline, thiéno[2,3b]thiophène, thiéno[3,2b]thiophène, dithiénothiophène, isobenzothiophène, dibenzothiophène et benzothiadiazothiophène.

3. Polymère selon la revendication 1 ou 2, **caractérisé en ce que** l'unité structurelle de la formule (I) est une unité structurelle de la formule (II) qui suit : 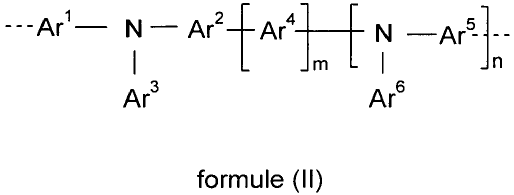 **caractérisé en ce qu'**au moins un Ar des unités Ar¹ à Ar⁶ contient un groupe aldéhyde,
formule dans laquelle les symboles et indices utilisés présentent les significations qui suivent :
Ar¹ à Ar⁶ sont identiques ou différents et représentent, indépendamment les uns des autres, un système de cycle aromatique ou hétéroaromatique monocyclique ou polycyclique substitué ou non substitué qui comporte 5 à 25 atomes de cycle ;
m est 0 ou 1 ;
n est 0, 1 ou 2 ;
les lignes en pointillés représentent des liaisons sur l'unité structurelle suivante du polymère ;
étant entendu que, si n = 1, les deux atomes de N sont liés à des atomes de C différents du même système de cycle aromatique.

4. Polymère selon une ou plusieurs des revendications 1 à 3, **caractérisé en ce que** Ar dans la formule (I) ou Ar¹, Ar², Ar⁴ et Ar⁵ dans la formule (II) est/sont une unité substituée ou non substituée qui est choisie parmi le groupe constitué par ce qui suit :
4,5-dihydropyrène, 4,5,9,10-tétrahydrofluorène, 9,9'-spirobifluorène, fluorène, phénanthrène, 9,10-dihydrophénanthrène, 5,7-dihydrodibenzoxépine, cis-indénofluorène, trans-indénofluorène, phénylène, thiophène, benzanthracène, carbazole, benzimidazole, oxépine et triazine.

5. Polymère selon la revendication 1, **caractérisé en ce que** l'autre unité structurelle est une unité structurelle de la formule (I) et/ou de la formule (II) qui ne contient pas un groupe aldéhyde.

6. Polymère selon une ou plusieurs des revendications 1 à 5, **caractérisé en ce que** Ar' dans la formule (I) ou Ar³ et/ou Ar⁶ dans la formule (II) contient/contiennent un groupe aldéhyde.

7. Polymère selon une ou plusieurs des revendications 3 à 6, **caractérisé en ce que** l'unité structurelle de la formule (II) est choisie parmi les unités structurelles qui suivent :

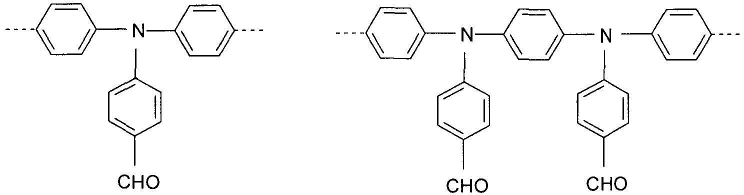

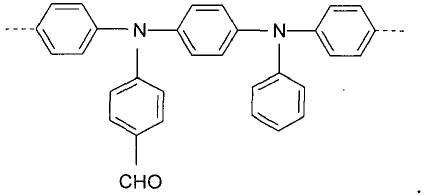

8. Mélange d'un ou de plusieurs polymère(s) selon une ou plusieurs des revendications 1 à 7 avec d'autres substances polymériques, oligomériques, dendritiques et/ou de poids moléculaire faible.

9. Formulation comprenant un ou plusieurs polymère(s) selon une ou plusieurs des revendications 1 à 7 ou comprenant un mélange selon la revendication 8 dans un ou plusieurs solvant(s).

10. Utilisation d'un polymère selon une ou plusieurs des revendications 1 à 7 pour la préparation d'un polymère réticulable et/ou réticulé.

11. Procédé pour la préparation d'un polymère réticulé, **caractérisé en ce qu'**il comprend les étapes qui suivent :
(a) fourniture de polymères selon une ou plusieurs des revendications 1 à 7, lesquels contiennent des groupes aldéhyde ;
(b) conversion des groupes aldéhyde selon des groupes vinyle ou alkényle réticulables ; et
(c) réticulation des polymères au moyen des groupes vinyle ou alkényle réticulables au moyen d'une réticulation sans radicaux ou ionique.
